# EUROPEAN PATENT APPLICATION

(11) **EP 4 773 438 A1**
(43) Date of publication of application: **08.07.2026**
(21) Application number: 24872840.4
(22) Date of filing: 23.09.2024
(51) Int. Cl.: H01Q 5/307, H01Q 1/22, H01Q 13/10, G06F 1/16, H05K 1/02

(54) **ELECTRONIC DEVICE COMPRISING ANTENNA**

(30) Priority: 27.09.2023 KR 20230130886; 07.11.2023 KR 20230152872
(71) Applicant: Samsung Electronics Co., Ltd., Suwon-si, Gyeonggi-do 16677 (KR)
(72) Inventor: YUN, Jiyeon, Suwon-si Gyeonggi-do 16677 (KR); KIM, Jongsuk, Suwon-si Gyeonggi-do 16677 (KR); CHOI, Donguk, Suwon-si Gyeonggi-do 16677 (KR); HAN, Sangmin, Suwon-si Gyeonggi-do 16677 (KR)
(74) Representative: HGF
(86) International application number: PCT/KR2024/014296
(87) International publication number: WO 2025/071132

(57) **Abstract**

This wearable device includes, a housing, a display disposed on at least a portion of the front surface of the wearable device, a first conductive member included in the housing or disposed in the housing, a second conductive member disposed in the housing to be adjacent to the first conductive member, a non-conductive member that is disposed along one side of an area in which the display is exposed through the front surface of the wearable device and that is supported by the first conductive member and the second conductive member, and a wireless communication circuit, wherein the wireless communication circuit may be configured to feed power to the first conductive member or the second conductive member and to transmit and/or receive radio frequency (RF) signals in a first frequency band on the basis of an electrical path formed in the first conductive member and the second conductive member.

## Description

### [Technical Field]

The disclosure relates to an electronic device including an antenna.

### [Background Art]

Smartphones and tablets have been widely used as user terminals, and the adoption of wearable electronic devices (e.g., smart watches or glasses) is also expanding. Such wearable electronic devices include an antenna for wireless communication therein. For example, in the case of a smart watch, a metal frame forming at least a portion of a side surface of the smart watch may be utilized as a radiator of the antenna.

Meanwhile, wearable electronic devices such as smart watches have difficulty covering various frequency bands due to size constraints, and have typically been released with an antenna supporting Wi-Fi or Bluetooth in the 2.4 GHz band without support for a cellular network.

### [Disclosure of Invention]

### [Solution to Problem]

According to an embodiment, a wearable device may include a housing, a display disposed on at least a portion of a front surface of the wearable device, a first conductive member included in the housing or disposed within the housing, a second conductive member disposed within the housing adjacent to the first conductive member, a non-conductive member disposed along one side of a region of the front surface of the wearable device where the display is exposed, the non-conductive member being supported by the first conductive member and the second conductive member, and a wireless communication circuit. The wireless communication circuit may be configured to feed power to the first conductive member or the second conductive member and to transmit and/or receive radio frequency (RF) signals in at least one frequency band based on an electrical path formed in the first conductive member and the second conductive member.

According to an embodiment, a wearable device may include a housing, a flexible display disposed on at least a portion of a front surface of the wearable device, a hinge connected to the flexible display so that the flexible display is folded or unfolded, a first conductive member included in the housing or disposed within the housing, a second conductive member disposed within the housing adjacent to the first conductive member, a non-conductive member disposed along one side of a region of the front surface of the wearable device where the display is exposed, the non-conductive member being supported by the first conductive member and the second conductive member, and a wireless communication circuit. The wireless communication circuit may be configured to feed power to the first conductive member or the second conductive member and to transmit and/or receive RF signals in at least one frequency band based on an electrical path formed in the first conductive member and the second conductive member.

### [Brief Description of Drawings]

FIG. 1 illustrates an electronic device in a network environment, according to an embodiment.
FIG. 2 is a view illustrating a first state and a second state of an electronic device according to an embodiment.
FIG. 3 is a cross-sectional view of an electronic device according to an embodiment.
FIG. 4 illustrates a case in which moving directions of a second display portion and a second housing according to an embodiment are opposite to each other.
FIG. 5A is a view illustrating a wireless communication circuit configured to feed power to a first conductive member according to an embodiment.
FIG. 5B is a view illustrating a connection member electrically connecting the wireless communication circuit and the first conductive member according to an embodiment.
FIG. 6 is a view illustrating current distributions according to respective states of the electronic device according to an embodiment.
FIG. 7 illustrates radiation efficiency graphs of an antenna including the first conductive member and the second conductive member when the wireless communication circuit feeds power to the first conductive member according to an embodiment.
FIG. 8A is a view illustrating a conductive member including a first conductive portion and a second conductive portion according to an embodiment.
FIG. 8B is a view illustrating conductive regions formed in a first region between a first conductive member and a second conductive member according to an embodiment.
FIG. 8C is a view illustrating a first conductive region formed in the first region between the first conductive member and the second conductive member according to an embodiment.
FIG. 8D is a view illustrating a first conductive material and a second conductive material disposed between the first conductive member and the second conductive member according to an embodiment.
FIG. 8E is a view illustrating a first conductive portion and a second conductive portion included in a first housing according to an embodiment.
FIG. 9 illustrates radiation efficiency graphs in a case in which a plurality of conductive regions are formed and in a case in which a plurality of conductive regions are not formed according to an embodiment.
FIG. 10A is a view illustrating a case in which a space between a first conductive member and a second conductive member is divided into a plurality of spaces according to an embodiment.
FIG. 10B is a view illustrating a case in which a space between a first conductive member and a second conductive member is divided into a plurality of spaces according to an embodiment.
FIG. 11 is a view illustrating a first state and a second state of an electronic device according to an embodiment.
FIG. 12 is a view illustrating a first state and a second state of an electronic device according to an embodiment.
FIG. 13 is a cross-sectional view of an electronic device according to an embodiment.
FIG. 14A is a view illustrating conductive regions formed in a first region between the first conductive member and the second conductive member according to an embodiment.
FIG. 14B is a view illustrating a second conductive region formed in the first region between the first conductive member and the second conductive member according to an embodiment.
FIG. 14C is a view illustrating a conductive member including a first conductive portion and a second conductive portion according to an embodiment.
FIG. 15 is a view illustrating current distributions according to frequency bands transmitted by the wireless communication circuit according to an embodiment.
FIG. 16 illustrates a radiation efficiency graph and a reflection coefficient graph of an antenna including the first conductive member and the second conductive member when the wireless communication circuit feeds power to the first conductive member according to an embodiment.
FIG. 17 illustrates a current distribution when the first part of the second housing moves in a direction away from the first housing and the wireless communication circuit feeds power to the first conductive member according to an embodiment.
FIG. 18 illustrates a current distribution when the first part and the second part of the second housing move in a direction away from the first housing and the wireless communication circuit feeds power to the first conductive member according to an embodiment.
FIG. 19 illustrates reflection coefficient graphs corresponding to cases in which the first part or the second part of the second housing according to an embodiment is slid out and in which the first part or the second part is not slid out.
FIG. 20 illustrates antenna radiation efficiency graphs corresponding to cases in which the first part or the second part of the second housing according to an embodiment is slid out and in which the first part or the second part is not slid out.
FIG. 21 illustrates a first state and a second state of an electronic device according to an embodiment.
FIG. 22 illustrates an electronic device including displays having different widths according to an embodiment.
FIG. 23 illustrates an electronic device including a second battery.
FIG. 24 is a view illustrating current distributions according to frequency bands transmitted by the wireless communication circuit according to an embodiment.
FIG. 25 illustrates a radiation efficiency graph and a reflection coefficient graph of an antenna including the first conductive member and the second conductive member when the wireless communication circuit feeds power to the first conductive member according to an embodiment.
FIG. 26 illustrates an electronic device including a foldable display according to an embodiment.
FIG. 27 illustrates an electronic device including a foldable display according to an embodiment.
FIG. 28 illustrates an electronic device including a foldable display according to an embodiment.
FIG. 29 illustrates an electronic device including a foldable display according to an embodiment.
FIG. 30 illustrates an electronic device having a circular shape according to an embodiment.

In the description of the drawings, the same or similar reference numerals may be used for the same or similar components.

### [Mode for the Invention]

Hereinafter, various embodiments of the disclosure will be described with reference to the accompanying drawings. However, this is not intended to limit the disclosure to specific embodiments, and it is to be understood that various modifications, equivalents, and/or alternatives of the embodiments of the disclosure are included within the scope of the disclosure.

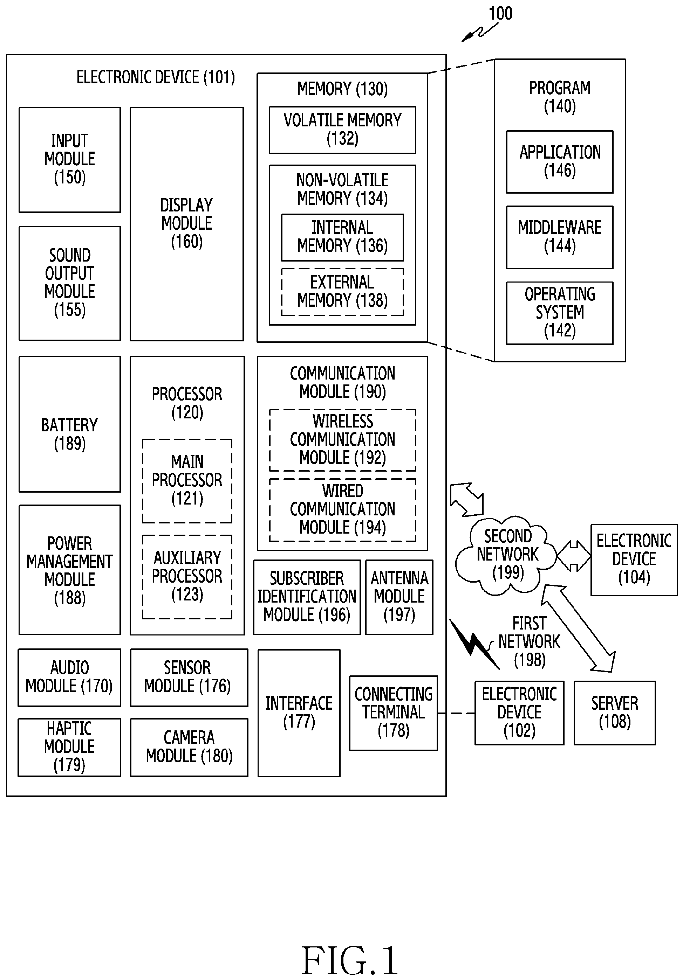

Fig. 1 is a block diagram illustrating an electronic device 101 in a network environment 100 according to various embodiments. Referring to Fig. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module(SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to one embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thererto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to one embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as BluetoothTM, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197. According to various embodiments, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

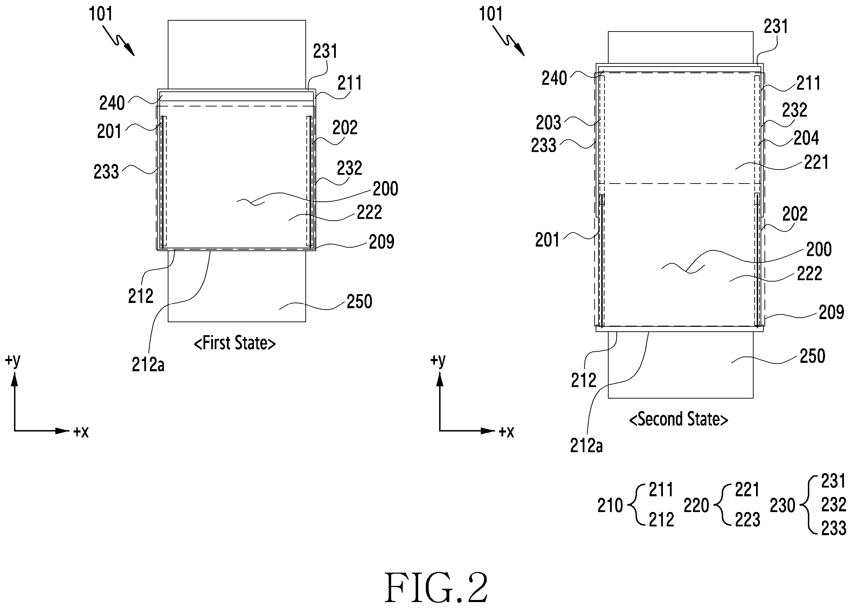

FIG. 2 is a view illustrating a first state and a second state of an electronic device according to an embodiment.

Referring to FIG. 2, an electronic device 101 (e.g., a wearable device) according to an embodiment may include a housing 210, a display 220, a non-conductive member 240, and/or a fastening member 250.

According to an embodiment, the housing 210 forming at least a portion of an exterior of the electronic device 101 may include a first housing 211 and/or a second housing 212. For example, the first housing 211 may be coupled to the fastening member 250 and may be fixed to the fastening member 250.

For example, the second housing 212 may be connected to the first housing 211 so as to be movable with respect to the first housing 211. For example, the second housing 212 may be a housing movable in a first direction (e.g., -y direction) or a second direction (e.g., +y direction) with reference to the first housing 211. In an example, the first direction (e.g., -y direction) may be a direction in which one side surface of the second housing 212 moves away from the first housing 211, and the second direction (e.g., +y direction) may be a direction in which the side surface of the second housing 212 moves closer to the first housing 211.

According to an embodiment, the electronic device 101 may include a first rail 201 and/or a second rail 202 connecting the second housing 212 and the first housing 211, and the second housing 212 may move closer to or away from the first housing 211 via the first rail 201 and/or the second rail 202.

For example, when the electronic device 101 is in the first state, a user may physically pull the second housing 212 in the first direction (e.g., -y direction). In this case, the first rail 201 of the second housing 212 may be in contact with a third rail 203 of the first housing 211 and move in the first direction (e.g., -y direction), and the second rail 202 of the second housing 212 may be in contact with a fourth rail 204 of the first housing 211 and move in the first direction (e.g., -y direction). As a result, one side surface of the second housing 212 may move away from the first housing 211.

As another example, when the electronic device 101 is in the second state, the user may physically push the second housing 212 in the second direction (e.g., +y direction). In this case, the first rail 201 of the second housing 212 may be in contact with the third rail 203 and move in the second direction (e.g., +y direction), and the second rail 202 of the second housing 212 may be in contact with the fourth rail 204 of the first housing 211 and move in the second direction (e.g., +y direction). As a result, one side surface of the second housing 212 may move toward the first housing 211.

According to an embodiment, the electronic device 101 may have a first state and a second state. For example, the first state may be a state in which the second housing 212 (or a second housing side surface portion 212a) is in contact with the first housing 211, and the second state may be a state in which the second housing 212 (or the second housing side surface portion 212a) is moved by a predetermined distance (e.g., a maximum movable distance). For example, the first state may be a state in which the second housing 212 (or the second housing side surface portion 212a) is as close as possible to the first housing 211, and the second state may be a state in which the second housing 212 (or the second housing side surface portion 212a) is as far as possible from the first housing 211.

In the disclosure, the second housing side surface portion 212a may refer to a portion of the second housing 212 forming a portion of a side surface of the electronic device 101. For example, the second housing 212 may include the second housing side surface portion 212a forming one side surface of the electronic device 101.

For example, the first state may be a state in which a first display portion 221 of the display 220 is slid into the first housing 211, and the second state may be a state in which at least a portion of the first display portion 221 is slid out from the first housing 211 and exposed on the front surface 200 of the electronic device 101.

According to an embodiment, the electronic device 101 may have a first state, a second state, and/or an intermediate state. For example, the intermediate state may be a state between the first state and the second state. For example, the intermediate state may refer to a state of the electronic device 101 while the electronic device 101 changes from the first state to the second state and a state of the electronic device 101 while the electronic device 101 changes from the second state to the first state.

For example, when the electronic device 101 is in the first state, a user may pull the second housing 212 in the first direction (e.g., -y direction). In this case, the state of the electronic device 101 while the second housing 212 moves in the first direction (e.g., -y direction) may be the intermediate state. For example, when the electronic device 101 is in the second state, the user may push the second housing 212 in the second direction (e.g., +y direction). In this case, the state of the electronic device 101 while the second housing 212 moves in the second direction (e.g., +y direction) may be the intermediate state. As another example, when the electronic device 101 is in the first state, the user may move the second housing 212 in the first direction (e.g., -y direction). In this case, the electronic device 101 may move by a distance smaller than a maximum movable distance of the second housing 212. The state in which the second housing 212 is moved by a distance smaller than the maximum movable distance may be referred to as the intermediate state.

According to an embodiment, the display 220 may include a first display portion 221 and/or a second display portion 222. For example, the first display portion 221 may include a portion slid into or slid out from the interior of the first housing 211, and the second display portion 222 may be a portion disposed on the front surface 200 of the electronic device 101 regardless of movement of the second housing 212.

For example, the first display portion 221 may be a portion slid into the interior of the first housing 211 when the electronic device 101 is in the first state, and the second display portion 222 may be a portion located outside the first housing 211 when the electronic device 101 is in the first state.

According to an embodiment, the display 220 may be a flexible display. For example, the display 220 may include the first display portion 221 that is bent or curved. As another example, the first display portion 221 and/or the second display portion 222 may be bent or curved.

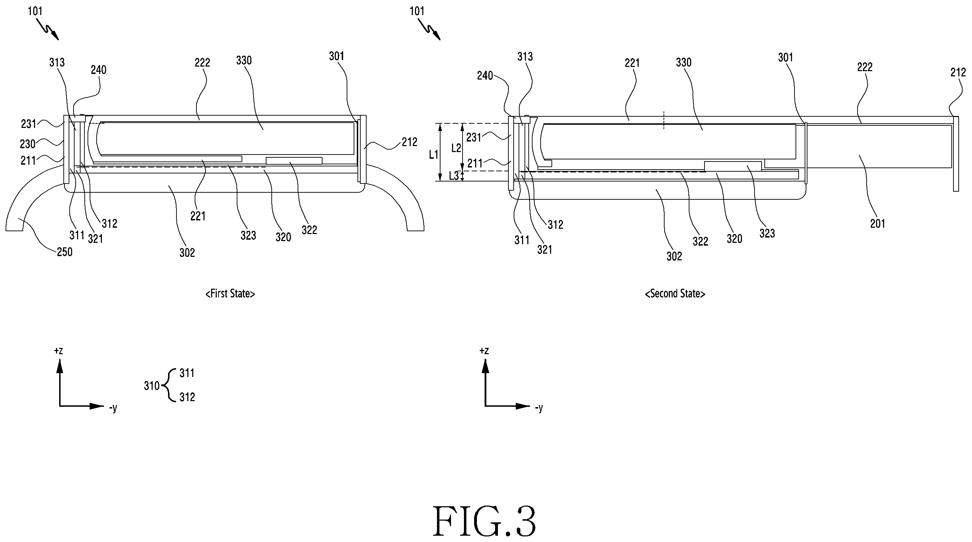

According to an embodiment, the first housing 211 may include a side surface member 230 and/or a rear surface cover (e.g., the rear surface cover 302 of FIG. 3). For example, the side surface member 230 may include a first side surface portion 231, a second side surface portion 232, and/or a third side surface portion 233. For example, the second side surface portion 232 may be substantially perpendicular to the first side surface portion 231. For example, the third side surface portion 233 may be substantially perpendicular to the first side surface portion 231 and substantially parallel to the second side surface portion 232.

For example, the first side surface portion 231 may face the second housing 212 (or the second housing side surface portion 212a). As another example, the first side surface portion 231 may be a portion corresponding to the second housing 212 (or the second housing side surface portion 212a). For example, the first side surface portion 231 may be symmetrical with the second housing 212 (or the second housing side surface portion 212a) with respect to a predetermined axis (e.g., the x-axis).

For example, the second side surface portion 232 and the third side surface portion 233 may face each other. As another example, the second side surface portion 232 may be a portion corresponding to the third side surface portion 233.

According to an embodiment, the side surface member 230 included in the first housing 211 may include a conductive material and/or a non-conductive material. For example, the first side surface portion 231 of the side surface member 230 may be formed of a conductive material. For example, the first side surface portion 231 of the side surface member 230 may include a conductive material and a non-conductive material. For example, the first side surface portion 231 of the side surface member 230 may be formed of a non-conductive material.

According to an embodiment, the non-conductive member 240 (e.g., plastic, rubber, or glass) may be disposed on the front surface 200 of the electronic device 101. For example, the non-conductive member 240 may be disposed on the front surface 200 of the electronic device 101 so as to be adjacent to the first side surface portion 231. For example, the non-conductive member 240 may be disposed to be spaced apart by a predetermined distance from one side of a region 209 where the display 220 is exposed on the front surface 200 of the electronic device 101.

According to an embodiment, when the first display portion 221 of the display 220 is slid into the interior of the first housing 211 or slid out from the interior of the first housing 211, the non-conductive member 240 may reduce or prevent foreign substances located outside the electronic device 101 from being introduced into the electronic device 101.

In FIG. 2 of the disclosure, movement of the second housing 212 or movement of the display 220 has been described as being performed by a physical force of a user, but this is merely an example. For example, the second housing 212 and/or the display 220 may move by a motor or a roller included in the electronic device 101. For example, the electronic device 101 may identify a user input (e.g., an input to the display 220 or a physical input to a key button), and the electronic device 101 may move the second housing 212 and/or the display 220 in the first direction (e.g., the -y direction) or the second direction (e.g., the +y direction) via a roller based on the user input.

In FIG. 2 of the disclosure, the display 220 has been described as a flexible display, but this is merely an example. For example, it will be apparent that the technical idea described with reference to FIGS. 2 to 30 may also be applied to an electronic device including a display that is not a flexible display. For example, an electronic device including a display that is not a flexible display may be understood as maintaining the first state.

In addition, with reference to FIG. 2 of the disclosure, the electronic device 101 has been described as a wearable device or a wearable electronic device, but this is merely an example. For example, the technical idea described with reference to FIGS. 2 to 30 may also be applied to a bar-type electronic device, a rollable terminal, and/or a foldable terminal.

FIG. 3 illustrates a cross-sectional view of an electronic device according to an embodiment.

Referring to FIG. 3, an electronic device 101 according to an embodiment may include a first conductive member 311, a second conductive member 312, a printed circuit board 320, a wireless communication circuit 323, and/or a battery 330.

According to an embodiment, a first housing 211 may include a side surface member 230 and/or a rear surface cover 302. For example, the rear surface cover 302 may form a rear surface of the electronic device 101 and may come into contact with a user's body (e.g., a wrist) when the electronic device 101 is mounted on the user's body (e.g., the wrist). For example, the rear surface cover 302 may include a non-conductive material. As another example, the rear surface cover 302 may include a non-conductive material and/or a conductive material.

According to an embodiment, the rear surface cover 302 may be coupled to the side surface member 230 so as to form an exterior of the electronic device 101. For example, the rear surface cover 302 may be coupled to a first side surface portion 231 of the side surface member 230.

According to an embodiment, a fastening member 250 (e.g., a strap) may be coupled to the side surface member 230 or the rear surface cover 302. For example, the fastening member 250 may be detachably coupled to the rear surface cover 302.

According to an embodiment, the first conductive member 311 and/or the second conductive member 312 may be disposed in the first housing 211 so as to be adjacent to the first side surface portion 231. For example, the first conductive member 311 may be in contact with the first side surface portion 231. For example, the first conductive member 311 may be disposed to be spaced apart from the first side surface portion 231 by a predetermined distance.

In FIG. 3 of the disclosure, the first conductive member 311 and the first side surface portion 231 are described as separate components of the first housing 211, but this is merely an example. For example, the first conductive member 311 may be included in the first side surface portion 231. For example, the first conductive member 311 may be included in the first housing 211 and may form a portion of the side surface member 230.

According to an embodiment, the second conductive member 312 may be disposed adjacent to the first conductive member 311. For example, the second conductive member 312 may be disposed adjacent to the first conductive member 311 within a distance that enables electromagnetic connection with the first conductive member 311. For example, the second conductive member 312 may be disposed adjacent to the first conductive member 311 within a distance that enables coupling connection with the first conductive member 311. For example, the second conductive member 312 may be arranged to be spaced apart from the first conductive member 311 by a predetermined distance.

According to an embodiment, the first conductive member 311 and/or the second conductive member 312 may have various shapes. For example, the first conductive member 311 and/or the second conductive member 312 may have a plate shape.

According to an embodiment, the first conductive member 311 and/or the second conductive member 312 may support the non-conductive member 240 (e.g., rubber or glass). For example, the first conductive member 311 may be disposed in a third direction (e.g., the -z direction) with respect to the non-conductive member 240 to support the non-conductive member 240. For example, the second conductive member 312 may be disposed in the third direction (e.g., the -z direction) with respect to the non-conductive member 240 to support the non-conductive member 240. For example, the first conductive member 311 may be disposed between the non-conductive member 240 and the rear surface cover 302, and the second conductive member 312 may be disposed between the non-conductive member 240 and the rear surface cover 302. For example, the second conductive member 312 may be disposed between the non-conductive member 240 and the printed circuit board 320.

For example, the second conductive member 312 may be disposed on the printed circuit board 320 to support the non-conductive member 240.

According to an embodiment, a dielectric material 313 (e.g., an injection-molded member or air) having a predetermined dielectric constant may be disposed between the first conductive member 311 and the second conductive member 312. For example, the dielectric constant of the dielectric material 313 may be determined based on a first frequency band in which the wireless communication circuit 323 is to transmit and/or receive signals based on the first conductive member 311 and the second conductive member 312. For example, the dielectric constant of the dielectric material 313 may be based on the first frequency band.

According to an embodiment, the printed circuit board 320 may provide electrical connection paths for various components in the electronic device 101 or may provide a space in which various components are disposed. For example, the processor 120 may be disposed on the printed circuit board 320, and the printed circuit board 320 may provide electrical paths that electrically connect the power management module 188 and the battery 330.

As another example, the wireless communication circuit 323 may be disposed on the printed circuit board 320 or within the printed circuit board 320, and the printed circuit board 320 may provide electrical paths (e.g., conductive paths 322) that electrically connect the wireless communication circuit 323 and the first conductive member 311 and/or the second conductive member 312.

According to an embodiment, the printed circuit board 320 may include a first region 321 located between the first conductive member 311 and the second conductive member 312. For example, when viewed in the third direction (e.g., the -z direction), the first region 321 may be disposed between the first conductive member 311 and the second conductive member 312. For example, when viewed in a direction toward an interior of the electronic device 101 (e.g., the -z direction), the first region 321 may be disposed between the first conductive member 311 and the second conductive member 312.

As another example, the first region 321 may be expressed as being disposed between the first conductive member 311 and the printed circuit board 320. For example, the first region 321 may be disposed between the printed circuit board 320 on which the second conductive member 312 is disposed and the first conductive member 311.

According to an embodiment, the first region 321 of the printed circuit board 320 may include a non-conductive material. For example, at least a portion of the first region 321 may be formed of a non-conductive material. For example, the first region 321 may be a non-conductive region formed by removing a metal layer (e.g., a ground layer) of the printed circuit board 320. For example, the first region 321 may be a peel-cut region or a cutting region formed by cutting a metal layer of the printed circuit board 320.

According to an embodiment, the wireless communication circuit 323 may be disposed on the printed circuit board 320 or within the printed circuit board 310.

According to an embodiment, the wireless communication circuit 323 may feed power to the first conductive member 311 and/or the second conductive member 312 via the printed circuit board 320. For example, a conductive path 322 may be formed on the printed circuit board 320. The wireless communication circuit 323 may provide or transmit radio frequency (RF) signals in the first frequency band to the first conductive member 311 and/or the second conductive member 312 via the conductive path 322.

In an example, the conductive path 322 may include a C-clip, a pogo pin, a conductive via, a conductive line, and/or an interposer, and a flexible printed circuit board (FPCB).

According to an embodiment, the wireless communication circuit 323 may include an intermediate frequency integrated circuit (IFIC) and/or an RFIC. For example, the wireless communication circuit 323 may process RF signals of an FR1 frequency band (e.g., 7.125 GHz) or lower, and in this case, the wireless communication circuit 323 may include only an RFIC. In an example, the RFIC of the wireless communication circuit 323 may convert baseband (BB) signals received from a communication processor (CP) of the processor 120 into RF signals and transmit the RF signals to an antenna radiator (e.g., the first conductive member 311).

As another example, the wireless communication circuit 323 may process RF signals of an FR2 frequency band (e.g., 24.25 GHz) or higher, and in this case, the wireless communication circuit 323 may include an IFIC and/or an RFIC. In an example, the IFIC of the wireless communication circuit 323 may convert BB signals received from the CP of the processor 120 into IF signals and transmit the IF signals to the RFIC, and the RFIC of the wireless communication circuit 323 may convert the IF signals into RF signals and transmit the RF signals to an antenna radiator (e.g., the first conductive member 311).

According to an embodiment, the battery 330 may feed power to at least some of electronic components included in the electronic device 101. For example, the battery 330 may feed power for a wireless communication circuit (e.g., an radio frequency integrated circuit (RFIC)) described below.

The battery 330 of FIG. 3 of the disclosure may correspond to the battery 189 of FIG. 1, and therefore the description of the battery 189 of FIG. 1 may be applied to the battery 330.

According to an embodiment, the first conductive member 311 may have a first length L1 (or a height) in a fourth direction (e.g., the +z direction). For example, the first length L1 may be a length between the non-conductive member 240 and the rear surface cover 302.

According to an embodiment, the second conductive member 312 may have a second length L2 (or a height) smaller than the first length L1. For example, the second length L2 may be a length between the non-conductive member 240 and the printed circuit board 320. In an example, the printed circuit board 320 may have a third length L3 (or a thickness) in the fourth direction (e.g., the +z direction), and the first length L1 may be substantially the sum of the second length L2 and the third length L3.

According to an embodiment, the electronic device 101 may include an inner housing 301. For example, the second housing 212 may move in the first direction (e.g., the -y direction) based on a user input or a physical force of a user, and as the inner housing 301 is fixed in position, the interior and the exterior of the electronic device 101 may be blocked from each other. For example, even when the second housing 212 moves in the first direction (e.g., the -y direction) or moves in the second direction (e.g., the +y direction), the inner housing 301 may reduce or prevent foreign substances located outside the electronic device 101 from being introduced into the electronic device 101.

According to an embodiment, the second display portion 222 of the display 220 may move together with the second housing 212 as the state of the electronic device 101 changes. For example, when the state of the electronic device 101 changes from the first state to the second state, the second housing 212 may move in the first direction (e.g., the -y direction), and the second display portion 222 may also move in the first direction (e.g., the -y direction). In the second state, at least a portion of the first display portion 221 may be exposed to the exterior of the electronic device 101.

As another example, when the state of the electronic device 101 changes from the second state to the first state, the second housing 212 may move in the second direction (e.g., the +y direction), and the second display portion 222 of the display 220 may also move in the second direction (e.g., the +y direction). In this case, the first display portion 221 may be slid into the interior of the first housing 211.

In FIG. 3 of the disclosure, the first conductive member 311 has been described as being disposed on the rear surface cover 302 to support the non-conductive member 240, and the second conductive member 312 has been described as being disposed on the printed circuit board 320 to support the non-conductive member 240, but this is merely an example. For example, the first conductive member 311 may be located on the printed circuit board 320 to support the non-conductive member 240. For example, the second conductive member 312 may be located on the rear surface cover 302 to support the non-conductive member 240.

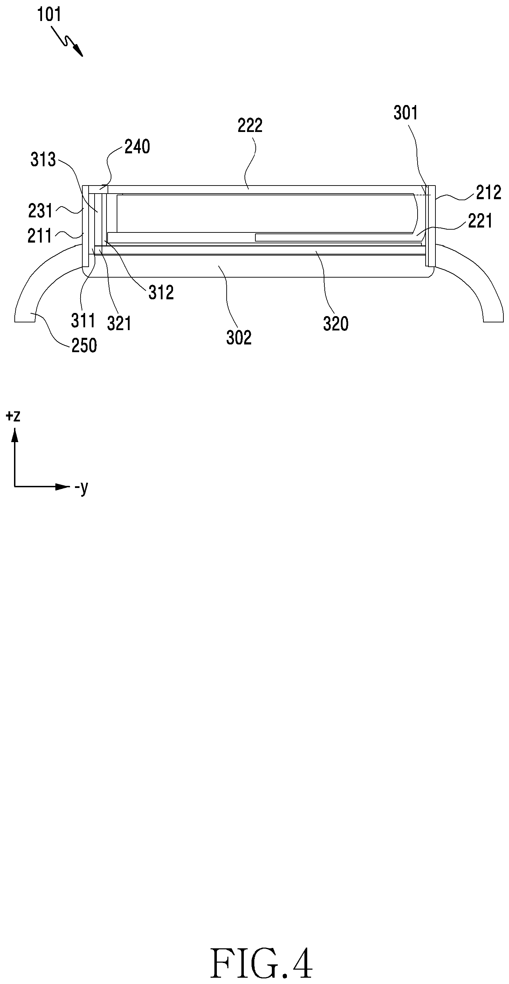

In FIG. 3 of the disclosure, a case in which the second display portion 222 of the display 220 moves in the same direction as the second housing 212 has been described, but this is merely an example. For example, the second display portion 222 may be fixed regardless of movement of the second housing 212, and only the first display portion 221 may move according to movement of the second housing 212. Hereinafter, a case in which only the first display portion 221 moves according to movement of the second housing 212 will be described with reference to FIG. 4.

The term "inner housing 301" of the disclosure is a term used to describe a housing distinguished from the first housing and the second housing, and may be replaced with another term. For example, the term "inner housing 301" may be replaced with the term "third housing," "frame," or "inner frame."

The term "conductive member" of the disclosure may be replaced with the term "conductive plate," "conductive portion," "conductive material," "metal plate," "electrical component," "metal body," or "conductive part."

In the disclosure, the side surface member 230 and the rear surface cover 302 have been described as being separate components that are coupled to each other, but this is merely an example. For example, the side surface member 230 and the rear surface cover 302 may be integrally formed.

FIG. 4 illustrates a case in which moving directions of the second display portion and the second housing according to an embodiment are opposite to each other.

Referring to FIG. 4, while the electronic device 101 according to an embodiment changes its state, the first display portion 221 may be slid out, and the second display portion 222 may not move. For example, while the electronic device 101 changes from the first state to the second state, the second housing 212 may move in the first direction (e.g., the -y direction). In this case, the second display portion 222 may not move, and only the first display portion 221 may be slid out from the interior of the first housing 211.

For example, while the electronic device 101 changes from the second state to the first state, the second housing 212 may move in the second direction (e.g., the +y direction). In this case, the second display portion 222 may not move, and only the first display portion 221 may be slid into the interior of the first housing 211.

In the embodiment of FIG. 4 of the disclosure, unlike the embodiment of FIG. 3, the second display portion 222 may be fixed regardless of a state change of the electronic device 101, and only the first display portion 221 may be slid out from the first housing 211 or slid into the first housing 211 based on the state change. For example, the second display portion 222 may be visible from the exterior through the front surface of the electronic device 101 regardless of the state change, and at least a portion of the first display portion 221 may be slid into or slid out from the interior of the electronic device 101 based on the state change.

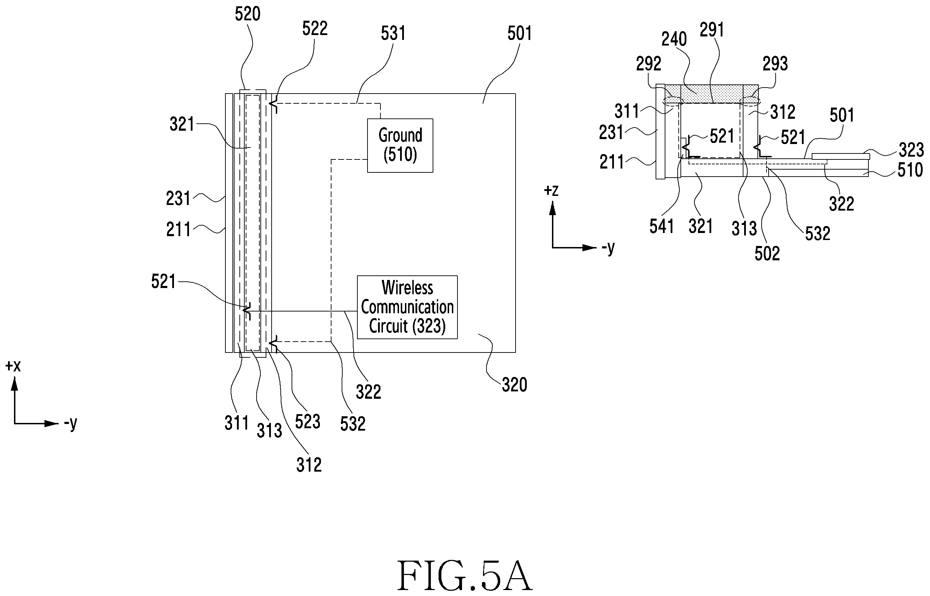

FIG. 5A is a view illustrating a wireless communication circuit configured to feed power to the first conductive member according to an embodiment.

Referring to FIG. 5A, the non-conductive member 240 according to an embodiment may be formed to extend along the first side surface portion 231 of the first housing 211. For example, the non-conductive member 240 may be formed to extend in a direction parallel to the first side surface portion 231 (e.g., the x-axis direction).

According to an embodiment, each of the first conductive member 311 and the second conductive member 312 may be formed to extend along the first side surface portion 231 of the first housing 211. For example, the first conductive member 311 may be formed to extend in a direction parallel to the first side surface portion 231 (e.g., the x-axis direction). For example, the second conductive member 312 may be formed to extend in a direction parallel to the first side surface portion 231 (e.g., the x-axis direction).

According to an embodiment, the first conductive member 311 and the second conductive member 312 may be formed to extend along one side of a bottom surface 291 of the non-conductive member 240. For example, the first conductive member 311 may be formed to extend along a first side 292 of the bottom surface 291 of the non-conductive member 240. For example, the second conductive member 312 may be formed to extend along a second side 293 of the bottom surface 291 of the non-conductive member 240. In an example, the second side may be opposite to the first side.

According to an embodiment, the wireless communication circuit 323 may be disposed on a first surface of the printed circuit board 320.

According to an embodiment, the wireless communication circuit 323 may be electrically connected to the first conductive member 311 through a conductive path 322. For example, at least a portion of the conductive path 322 may be formed on a first region 321 of the printed circuit board 320, and the conductive path 322 may be in contact with a first conductive connection member 521 (e.g., an L-clip) on the first region 321. The first conductive connection member 521 may be in contact with a first protrusion 541 of the first conductive member 311. For example, the wireless communication circuit 323 may be electrically connected to the first conductive member 311 via the conductive path 322, the first conductive connection member 521, and the first protrusion 541.

According to an embodiment, the electronic device 101 may include a ground 510. For example, the ground 510 may be formed in the printed circuit board 320. For example, the printed circuit board 320 may include a plurality of conductive layers and non-conductive layers that alternate with each other, and the ground 510 may be formed on at least some of the plurality of conductive layers. For example, the ground 510 may correspond to a ground for the first conductive member 311 and the second conductive member 312 operating as antenna radiators.

According to an embodiment, the ground 510 may be electrically connected to the second conductive member 312 through a first conductive path 531 and a second conductive connection member 522. For example, the wireless communication circuit 323 may feed power to the first conductive member 311, and a current formed in the first conductive member 311 may flow to the second conductive member 312 through coupling. In this case, the current formed in the second conductive member 312 through coupling may flow to the ground 510 via the first conductive path 531 and the second conductive connection member 522.

According to an embodiment, the ground 510 may be electrically connected to the second conductive member 312 through a second conductive path 532 and a third conductive connection member 523. For example, the current formed in the second conductive member 312 may flow to the ground 510 via the second conductive path 532 and the third conductive connection member 523.

In the disclosure, the ground 510 has been described as being electrically connected to the second conductive member 312 via the second conductive connection member 522 and the third conductive connection member 523, but this is merely an example. For example, the ground 510 may be electrically connected to the second conductive member 312 through only one of the second conductive connection member 522 and the third conductive connection member 523. As another example, the ground 510 may be electrically connected to the second conductive member 312 through an additional conductive connection member other than the second conductive connection member 522 and the third conductive connection member 523.

According to an embodiment, the wireless communication circuit 323 may feed power to the first conductive member 311 via the conductive path 322, and may transmit and/or receive RF signals in at least one frequency band (e.g., a first frequency band and a second frequency band) based on an electrical path 520 formed in the first conductive member 311 and the second conductive member 312. For example, as the wireless communication circuit 323 feeds power to the first conductive member 311, the electrical path 520 may be formed in the first conductive member 311 and the second conductive member 312. In this case, the wireless communication circuit 323 may transmit and/or receive RF signals in at least one frequency band based on the electrical path 520. For example, the at least one frequency band may include the first frequency band (e.g., a frequency band including 1.5 GHz) and/or the second frequency band (e.g., a frequency band including 2.4 GHz).

According to an embodiment, a dielectric material 313 having a predetermined dielectric constant may be disposed between the first conductive member 311 and the second conductive member 312. With reference to FIG. 5A of the disclosure, the dielectric material 313 (e.g., air) has been described as being disposed between the first conductive member 311 and the second conductive member 312, but this is merely an example. For example, a plurality of dielectric materials having different dielectric constants may be disposed between the first conductive member 311 and the second conductive member 312.

With reference to FIG. 5A of the disclosure, the wireless communication circuit 323 has been described as feeding power to the first conductive member 311 via the conductive path 322 and the first conductive connection member 521, but this is merely an example. For example, the wireless communication circuit 323 may feed the first conductive member 311 through coupling feeding (or indirect feeding).

With reference to FIG. 5A of the disclosure, the wireless communication circuit 323 has been described as feeding power to the first conductive member 311 and the second conductive member 312 being connected to the ground 510, but this is merely an example. For example, the wireless communication circuit 323 may feed power to the second conductive member 312, and the ground 510 may be electrically connected to the first conductive member 311. In this case, as the wireless communication circuit 323 feeds power to the second conductive member 312, a current may be formed in the second conductive member 312. The formed current may flow to the first conductive member 311 through coupling, and the current formed in the first conductive member 311 may flow to the ground 510.

With reference to FIG. 5A of the disclosure, the ground 510 has been described as being formed in the printed circuit board 320, but this is merely an example. For example, the ground 510 may be formed in various electrical components (e.g., an FPCB or a bracket) included in the electronic device 101.

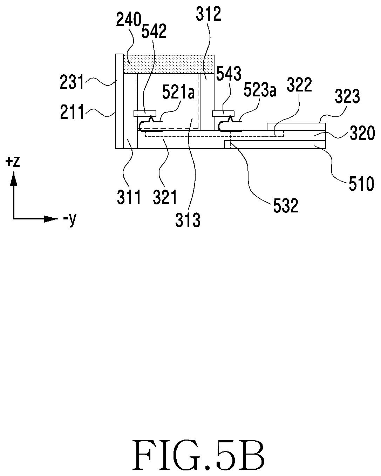

With reference to FIG. 5A of the disclosure, the wireless communication circuit 323 has been described as being electrically connected to the first conductive member 311 via the first conductive connection member (e.g., an L-clip), but this is merely an example. For example, the wireless communication circuit 323 may be electrically connected to the first conductive member 311 through various connection members (e.g., a C-clip). Hereinafter, a case in which the wireless communication circuit 323 is electrically connected to the first conductive member 311 through a first connection member 521a (e.g., a C-clip) will be described with reference to FIG. 5B.

With reference to FIG. 5A of the disclosure, the wireless communication circuit 323 has been described as being disposed on the first surface 501 of the printed circuit board 320, but this is merely an example. For example, the wireless communication circuit 323 may be disposed on the second surface 502 of the printed circuit board 320. In this case, the wireless communication circuit 323 may be electrically connected to the first conductive connection member 521 through a conductive via penetrating the second surface 502 and the first surface 501 of the printed circuit board 320 and electrically connecting the second surface 502 and the first surface 501. For example, the wireless communication circuit 323 may be disposed in the printed circuit board 320.

FIG. 5B is a view illustrating a connection member electrically connecting the wireless communication circuit and the first conductive member according to an embodiment.

Referring to FIG. 5B, a second protrusion 542 may be formed on the first conductive member 311 according to an embodiment, and a third protrusion 543 may be formed on the second conductive member 312. For example, the second protrusion 542 may be a portion extending from the first conductive member 311 in the first direction (e.g., the -y direction), and the third protrusion 543 may be a portion extending from the second conductive member 312 in the first direction (e.g., the -y direction). For example, the first direction may be a direction substantially perpendicular to the first conductive member 311 and the second conductive member 312.

According to an embodiment, the electronic device 101 may include a first connection member 521a and/or a second connection member 523a. For example, the first connection member 521a may be disposed between the second protrusion 542 and the first region 321, and the second connection member 523a may be disposed between the third protrusion 543 and the printed circuit board 320. In an example, the first connection member 521a may electrically connect the second protrusion 542 and the conductive path 322 formed on the first region 321. The second connection member 523a may electrically connect the third protrusion 543 and the second conductive path 532.

According to an embodiment, the wireless communication circuit 323 may be electrically connected to the first conductive member 311 via the conductive path 322, the first connection member 521a, and the second protrusion 542. The ground 510 may be electrically connected to the second conductive member 312 via the second conductive path 532, the second connection member 523a, and the third protrusion 543.

In the embodiment of FIG. 5B of the disclosure, unlike the embodiment of FIG. 5A in which the first conductive connection member 521 (e.g., an L-clip) is illustrated, the electronic device 101 may include the first connection member 521a (e.g., a C-clip) and/or the second connection member 523a.

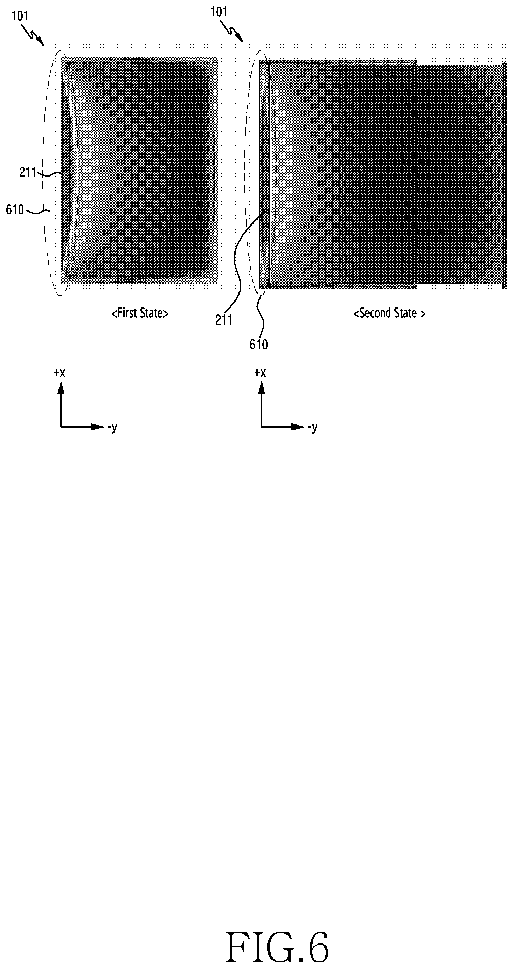

FIG. 6 is a view illustrating current distributions according to respective states of the electronic device according to an embodiment.

Referring to FIG. 6, a current distribution formed in the electronic device 101 when the wireless communication circuit 323 according to an embodiment feeds power to the first conductive member 311 is illustrated.

In the disclosure, the first conductive member 311 and the second conductive member 312 in the electronic device 101 are not illustrated, but a first region 610 may be understood as a region substantially including the first conductive member 311 and the second conductive member 312.

According to an embodiment, as the wireless communication circuit 323 transmits RF signals in a first frequency band (e.g., about 1.5 GHz) and/or a second frequency band (e.g., 2.4 GHz) to the first conductive member 311, a current may be formed in the first region 610 of the electronic device 101. For example, substantially the same current distribution may be formed in the first region 610 when the electronic device 101 is in a first state and when the electronic device 101 is in a second state.

For example, the electronic device 101 may secure substantially the same current distribution regardless of the state of the electronic device 101, and as a result, the electronic device 101 may secure substantially the same radiation performance in the first frequency band (e.g., about 1.5 GHz) and/or the second frequency band (e.g., 2.4 GHz) regardless of the state of the electronic device 101.

For example, the size and position of the display 220 may vary when the electronic device 101 is in the first state and when the electronic device 101 is in the second state. The display 220 may include a metal layer, and when the shape and position of the display 220 are changed according to a state change of the electronic device 101, radiation performance of an antenna disposed adjacent to the display 220 may deteriorate. On the other hand, when the electronic device 101 according to an embodiment transmits and/or receives RF signals in the first frequency band (e.g., about 1.5 GHz) and/or the second frequency band (e.g., 2.4 GHz) based on the first conductive member 311 and the second conductive member 312 included in or disposed on the first housing 211, the electronic device 101 may secure substantially the same radiation performance in the second state as in the first state.

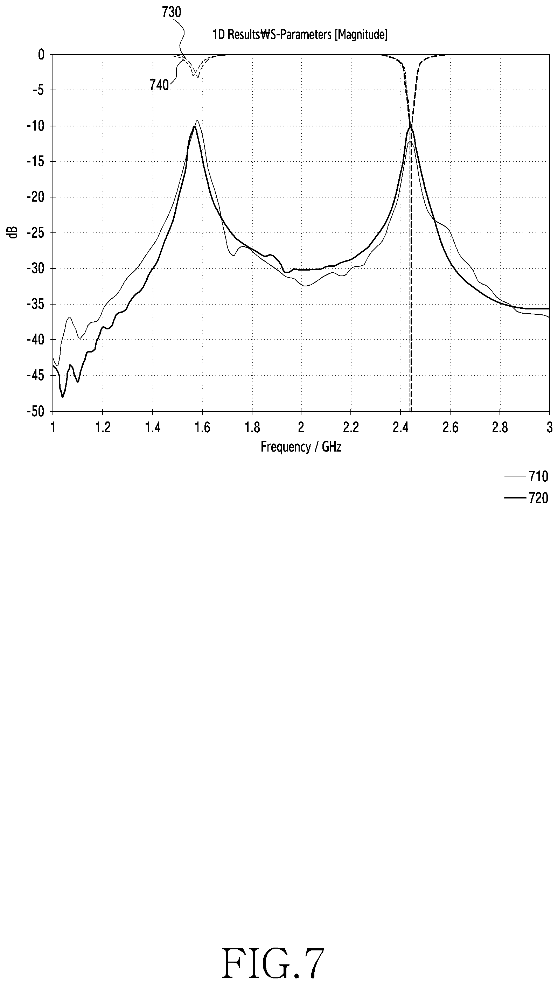

FIG. 7 illustrates radiation efficiency graphs of an antenna including the first conductive member and the second conductive member when the wireless communication circuit feeds power to the first conductive member according to an embodiment.

Referring to FIG. 7, a first graph 710 according to an embodiment is a radiation efficiency graph of an antenna including the first conductive member 311 and the second conductive member 312 when the wireless communication circuit 323 feeds power to the first conductive member 311 while the electronic device 101 is in the first state. A second graph 720 is a radiation efficiency graph of an antenna including the first conductive member 311 and the second conductive member 312 when the wireless communication circuit 323 feeds power to the first conductive member 311 while the electronic device 101 is in the second state.

According to an embodiment, a third graph 730 is a reflection coefficient graph of signals radiated by an antenna including the first conductive member 311 and the second conductive member 312 when the wireless communication circuit 323 feeds power to the first conductive member 311 while the electronic device 101 is in the second state. A fourth graph 740 is a reflection coefficient graph of signals radiated by an antenna including the first conductive member 311 and the second conductive member 312 when the wireless communication circuit 323 feeds power to the first conductive member 311 while the electronic device 101 is in the first state.

Comparing the first graph 710 and the second graph 720 according to an embodiment, the first graph 710 and the second graph 720 each show radiation efficiency values of about 20 dB or greater in each of the first frequency band (e.g., about 1.5 GHz) and the second frequency band (e.g., about 2.4 GHz to about 2.5 GHz).

Comparing the third graph 730 and the fourth graph 740 according to an embodiment, it is confirmed that the third graph 730 and the fourth graph 740 show reflection coefficient values of about -3 dB or less in the first frequency band (e.g., about 1.5 GHz), and show reflection coefficient values of about -5 dB or less in the second frequency band (e.g., about 2.4 GHz to about 2.5 GHz).

As a result, the electronic device 101 may secure antenna radiation performance greater than or equal to a predetermined value for each of the first frequency band (e.g., about 1.5 GHz) and the second frequency band (e.g., 2.5 GHz) in both the first state and the second state regardless of the state of the electronic device 101.

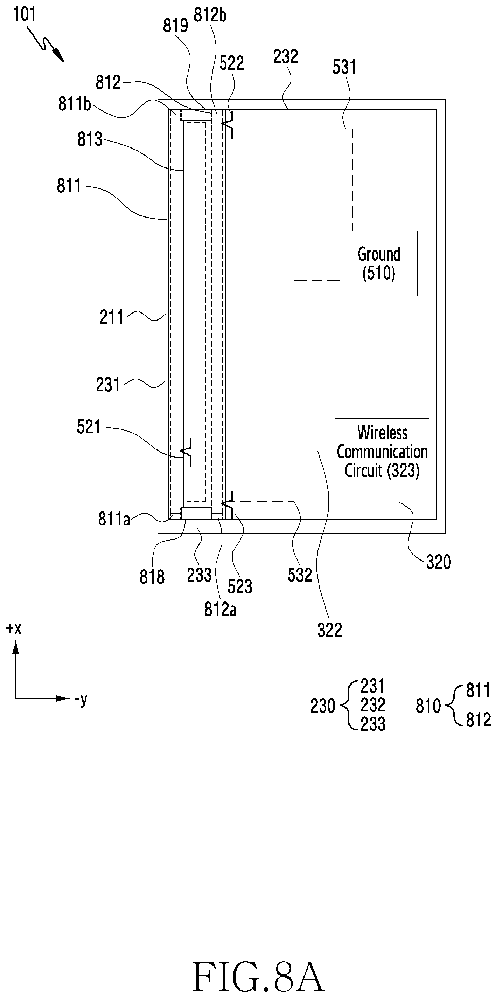

FIG. 8A is a view illustrating a conductive member including a first conductive portion and a second conductive portion according to an embodiment.

Referring to FIG. 8A, an electronic device 101 according to an embodiment may include a conductive member 810 disposed adjacent to the first side surface portion 231.

According to an embodiment, at least a portion of the side surface member 230 may be formed of a non-conductive material. For example, the first side surface portion 231 may be formed of a non-conductive material. For example, the second side surface portion 232 may be formed of a non-conductive material. For example, the third side surface portion 233 may be formed of a non-conductive material.

The conductive member 810 of FIG. 8A of the disclosure may correspond to a case in which the first conductive member 311 and the second conductive member 312 of FIG. 3 are integrally formed. For example, the conductive member 810 may include a first conductive portion 811 and a second conductive portion 812, and the first conductive portion 811 and the second conductive portion 812 may be connected via a first connecting portion 818 and a second connecting portion 819. For example, a first end 811a of the first conductive portion 811 may be connected to a second end 812a of the second conductive portion 812 via the first connecting portion 818. A third end 811b of the first conductive portion 811 may be connected to a fourth end 812b of the second conductive portion 812 via the second connecting portion 819.

For example, the conductive member 810 may have a rectangular shape. However, the shape of the conductive member 810 is not limited to the rectangular shape and may correspond to various shapes.

For example, the first conductive portion 811 of FIG. 8A may correspond to the first conductive member 311 of FIG. 3, and the second conductive portion 812 of FIG. 8A may correspond to the second conductive member 312 of FIG. 3.

According to an embodiment, a slot 813 may be formed in the conductive member 810. For example, the slot 813 may be a cavity formed in the conductive member 810. For example, a non-conductive material or a dielectric material (e.g., air or an injection-molded material) may be disposed in the slot 813.

According to an embodiment, the wireless communication circuit 323 may feed power to the first conductive portion 811 of the conductive member 810 via the conductive path 322 and the first conductive connection member 521. The wireless communication circuit 323 may transmit and/or receive RF signals in at least one frequency band based on an electrical path formed in the conductive member 810. For example, the at least one frequency band may include a first frequency band (e.g., about 1.5 GHz) and/or a second frequency band (e.g., about 2.4 GHz to about 2.5 GHz).

According to an embodiment, the first side surface portion 231 of the first housing 211 may be formed of a conductive material and/or a non-conductive material. For example, the first side surface portion 231 may be a component separate from the conductive member 810. In this case, the first side surface portion 231 may be in contact with the conductive member 810 or may be spaced apart from the conductive member 810 by a predetermined distance. The first side surface portion 231 may be formed of a non-conductive material so that RF signals in the first frequency band radiated from the conductive member 810 are radiated to the exterior of the electronic device 101.

As another example, a portion of the conductive member 810 may be included in the first housing 211. For example, a portion of the conductive member 810 may extend from the first side surface portion 231 of the first housing 211 and may be integrally formed therewith. In this case, the first side surface portion 231 may be formed of a conductive material.

As another example, a portion of the conductive member 810 may be configured to form the first side surface portion 231 of the first housing 211. In this case, the first side surface portion 231 may be formed as the first conductive portion 811.

In FIG. 8A of the disclosure, the term "slot" may be replaced with the term "hole," "opening," "slit," "pit," and/or "opening portion."

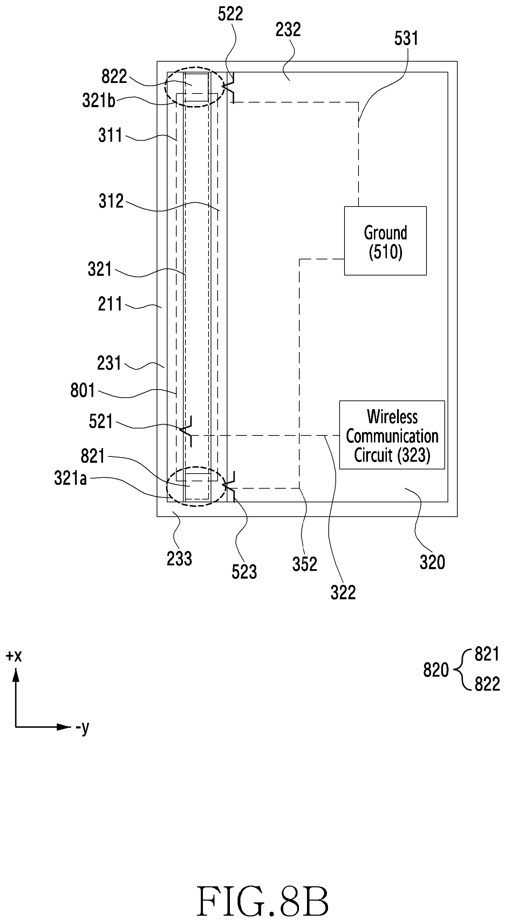

FIG. 8B is a view illustrating conductive regions formed in a first region between the first conductive member and the second conductive member according to an embodiment.

Referring to FIG. 8B, a plurality of conductive regions 820 may be formed or disposed in the first region 321 according to an embodiment. For example, the printed circuit board 320 may include the first region 321 disposed between the first conductive member 311 and the second conductive member 312. In an embodiment, a first conductive region 821 may be formed at a first end 321a of the first region 321, and a second conductive region 822 may be formed at a second end 321b of the first region 321.

According to an embodiment, the first conductive region 821 and/or the second conductive region 822 may correspond to a portion of a conductive layer of the printed circuit board 320.

According to an embodiment, the first conductive region 821 and the second conductive region 822 may electrically connect the first conductive member 311 and the second conductive member 312. For example, the first conductive region 821 may electrically connect the first conductive member 311 and the second conductive member 312 at the first end 321a of the first region 321. For example, the second conductive region 822 may electrically connect the first conductive member 311 and the second conductive member 312 at the second end 321b of the first region 321.

In the embodiment of FIG. 8B of the disclosure, a closed slot may be defined as the first conductive member 311 and the second conductive member 312 are connected via the plurality of conductive regions 820. On the other hand, in the embodiment of FIG. 8A, as the plurality of conductive regions 820 are not present, the first conductive member 311 and the second conductive member 312 may define an open slot.

According to an embodiment, as the first conductive region 821 and the second conductive region 822 connect the first conductive member 311 and the second conductive member 312, the first conductive member 311 and the second conductive member 312 may have substantially the same structure as the conductive member 810 of FIG. 8A. For example, when the first conductive region 821 and the second conductive region 822 are not formed, the first conductive member 311 and the second conductive member 312 may be spaced apart from each other and may be electromagnetically (or capacitively) connected through coupling. On the other hand, when the first conductive region 821 and the second conductive region 822 according to an embodiment are formed, the first conductive member 311 and the second conductive member 312 may be directly connected to each other rather than being connected through coupling. In this case, the first conductive member 311 and the second conductive member 312 may have substantially the same structure as that of the conductive member 810 of FIG. 8A formed integrally.

According to an embodiment, the wireless communication circuit 323 may feed power to the first conductive member 311 via the conductive path 322 and the first conductive connection member 521. The wireless communication circuit 323 may transmit and/or receive RF signals in a third frequency band based on an electrical path 801 (indicated by a dotted line) formed in the first conductive member 311, the second conductive member 312, the first conductive region 821, and the second conductive region 822.

According to an embodiment, as the first conductive region 821 and the second conductive region 822 are formed, an electrical path 801 formed in the first conductive member 311 and the second conductive member 312 may be relatively shorter than the electrical path 520 of FIG. 5A. As the electrical path 801 becomes shorter than the electrical path 520 of FIG. 5A, the third frequency band may be relatively higher than the first frequency band.

In the disclosure, the term "conductive region" may be replaced with the term "conductive layer," "conductive connection portion," "connecting portion," "ground region," or "ground fill region."

In the disclosure, the first conductive region 821 and the second conductive region 822 have been described as being formed in the first region 321, but this is merely an example. For example, the first region 321 may also be described as including the first conductive region 821 and the second conductive region 822.

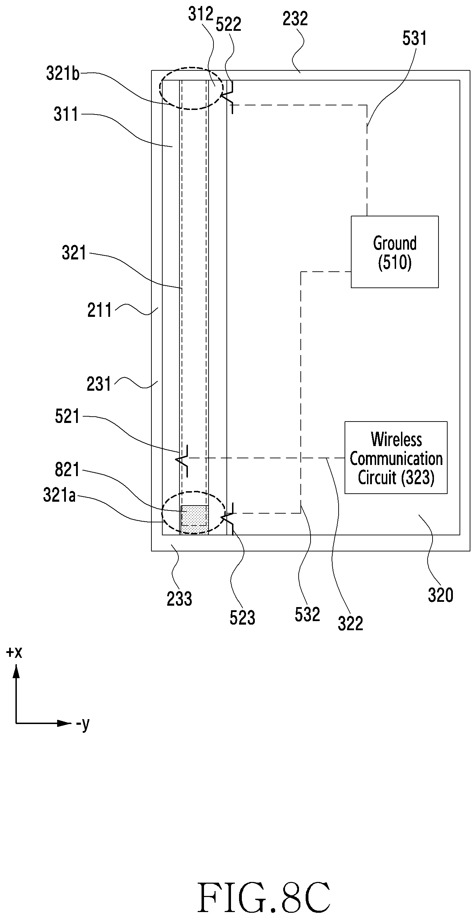

FIG. 8C is a view illustrating a first conductive region formed in the first region between the first conductive member and the second conductive member according to an embodiment.

Referring to FIG. 8C, a first conductive region 821 may be formed at the first end 321a of the first region 321 according to an embodiment. For example, the first conductive region 821 may correspond to a portion of a conductive layer of the printed circuit board 320.

The embodiment of FIG. 8C of the disclosure may correspond to an embodiment in which the second conductive region 321b of the embodiment of FIG. 8B is omitted.

According to an embodiment, the first conductive region 821 may electrically connect the first conductive member 311 and the second conductive member 312. For example, the first conductive region 821 may electrically connect the first conductive member 311 and the second conductive member 312 at the first end 321a of the first region 321.

According to an embodiment, the first conductive member 311 and the second conductive member 312 may also be electromagnetically (or capacitively) connected through coupling at the second end 321b of the first region 321.

According to an embodiment, the wireless communication circuit 323 may feed power to the first conductive member 311 via the conductive path 322 and the first conductive connection member 521. The wireless communication circuit 323 may transmit and/or receive RF signals in a fifth frequency band based on an electrical path formed in the first conductive member 311, the second conductive member 312, and/or the first conductive region 821.

According to an embodiment, as the first conductive region 821 is formed, the electrical path formed in the first conductive member 311, the second conductive member 312, and the first conductive region 821 may be shorter than the electrical path 520 of FIG. 5A. Accordingly, the fifth frequency band may be a frequency band relatively higher than at least one frequency band (e.g., the first frequency band).

In the disclosure, the term "conductive region" may be replaced with the term "conductive layer," "conductive connection portion," "connecting portion," "ground region," or "ground fill region."

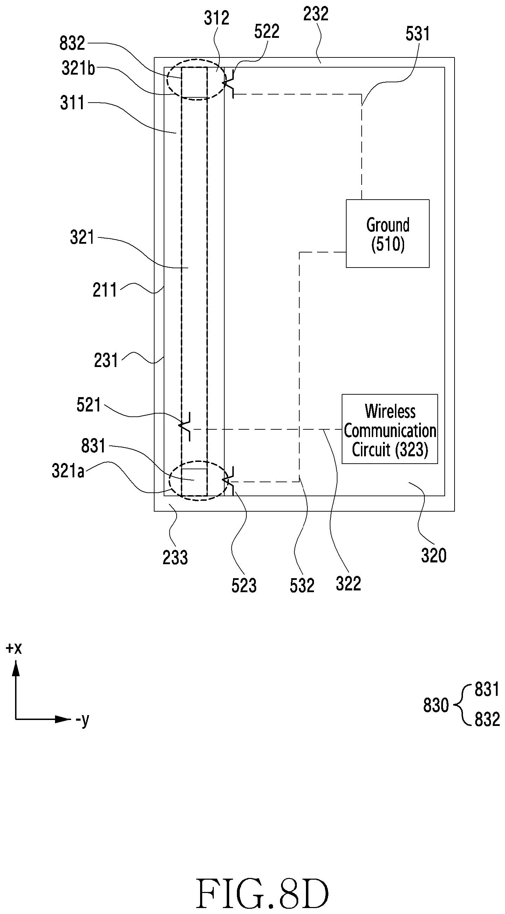

FIG. 8D is a view illustrating a first conductive material and a second conductive material disposed between the first conductive member and the second conductive member according to an embodiment.

Referring to FIG. 8D, a plurality of conductive materials 830 may be formed or disposed on the first region 321 according to an embodiment. For example, the printed circuit board 320 may include the first region 321 disposed between the first conductive member 311 and the second conductive member 312. A first conductive material 831 may be formed at the first end 321a of the first region 321, and a second conductive material 832 may be formed at the second end 321b of the first region 321.

According to an embodiment, the first conductive material 831 and the second conductive material 832 may electrically connect the first conductive member 311 and the second conductive member 312. For example, the first conductive material 831 may electrically connect the first conductive member 311 and the second conductive member 312 at the first end 321a of the first region 321. For example, the second conductive material 832 may electrically connect the first conductive member 311 and the second conductive member 312 at the second end 321b of the first region 321.

According to an embodiment, as the first conductive material 831 and the second conductive material 832 connect the first conductive member 311 and the second conductive member 312, the first conductive member 311 and the second conductive member 312 may have substantially the same structure as the conductive member 810 of FIG. 8A. For example, when the first conductive material 831 and the second conductive material 832 are not formed, the first conductive member 311 and the second conductive member 312 may be spaced apart from each other and may be electromagnetically connected through coupling. On the other hand, when the first conductive material 831 and the second conductive material 832 according to an embodiment are formed, the first conductive member 311 and the second conductive member 312 may be directly connected rather than being connected through coupling. In this case, the first conductive member 311 and the second conductive member 312 may have substantially the same structure as that of the conductive member 810 of FIG. 8A formed integrally.

In the embodiment of FIG. 8D of the disclosure, unlike the embodiment of FIG. 8B, separate conductive materials (e.g., the first conductive material 831 and the second conductive material 832) may be disposed between the first conductive member 311 and the second conductive member 312 to connect the first conductive member 311 and the second conductive member 312.

According to an embodiment, the wireless communication circuit 323 may feed power to the first conductive member 311 via the conductive path 322 and the first conductive connection member 521. The wireless communication circuit 323 may transmit and/or receive RF signals in a predetermined frequency band based on an electrical path formed in the first conductive member 311, the second conductive member 312, the first conductive material 831, and the second conductive material 832.

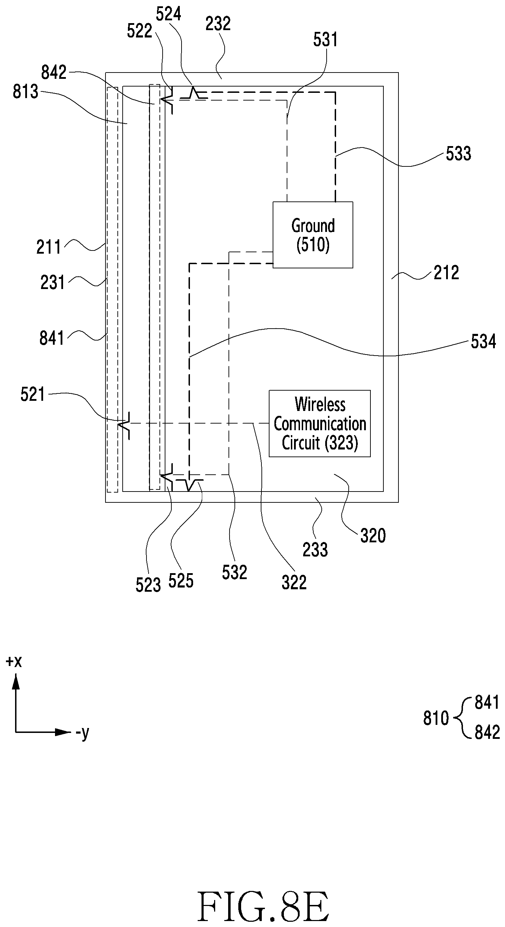

FIG. 8E is a view illustrating a first conductive portion and a second conductive portion included in the first housing according to an embodiment.

Referring to FIG. 8E, the first housing 211 according to an embodiment may include a first conductive portion 841 and/or a second conductive portion 842. For example, the first housing 211 may include the first conductive portion 841 included in the first side surface portion 231. For example, the first housing 211 may include the second conductive portion 842 connecting the second side surface portion 232 and the third side surface portion 233.

As another example, the first housing 211 may include the second conductive portion 842 extending parallel to the first side surface portion 231 and connecting the second side surface portion 232 and the third side surface portion 233.

In the embodiment of FIG. 8E of the disclosure, unlike the embodiment of FIG. 8A, the first conductive portion 841 may form the first side surface portion 231, and the second conductive portion 842 may be included in the first housing 211.

According to an embodiment, the wireless communication circuit 323 may feed power to the first conductive member 311 via the conductive path 322 and the first conductive connection member 521. The wireless communication circuit 323 may transmit and/or receive RF signals in a predetermined frequency band based on an electrical path formed in the first conductive portion 841 and the second conductive portion 842.

According to an embodiment, the ground 510 may be electrically connected to the second side surface portion 232 through a third conductive path 533 and a fourth conductive connection member 524. For example, the ground 510 may be electrically connected to the fourth conductive connection member 524 via the third conductive path 533, and the fourth conductive connection member 524 may be electrically connected to the second side surface portion 232 of the first housing 211.

According to an embodiment, the ground 510 may be electrically connected to the third side surface portion 233 through a fourth conductive path 534 and a fifth conductive connection member 525. For example, the ground 510 may be electrically connected to the fifth conductive connection member 525 via the fourth conductive path 534, and the fifth conductive connection member 525 may be electrically connected to the third side surface portion 233 of the first housing 211.

According to an embodiment, as the wireless communication circuit 323 feeds power to the first conductive portion 841 of the first side surface portion 231, an electrical path may be formed in at least a portion of the second side surface portion 232 and/or the third side surface portion 233.

According to an embodiment, the wireless communication circuit 323 may transmit and/or receive RF signals in a predetermined frequency band based on an electrical path formed in the second side surface portion 232. A current formed in the second side surface portion 232 may be grounded to the ground 510 via the third conductive path 533 and the fourth conductive connection member 524.

According to an embodiment, the wireless communication circuit 323 may transmit and/or receive RF signals in a predetermined frequency band based on an electrical path formed in the third side surface portion 233. A current formed in the third side surface portion 233 may be grounded to the ground 510 via the fourth conductive path 534 and the fifth conductive connection member 525.

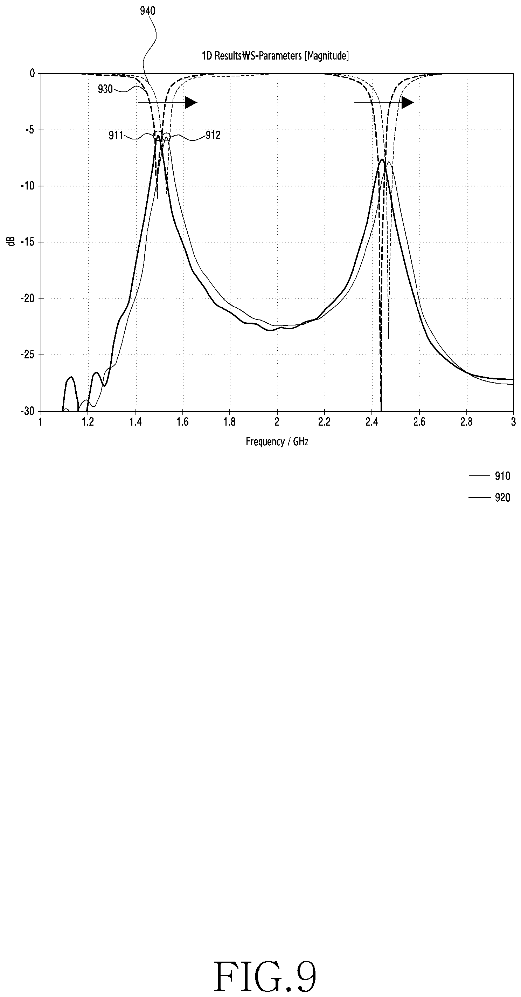

FIG. 9 illustrates radiation efficiency graphs in a case in which a plurality of conductive regions are formed and in a case in which a plurality of conductive regions are not formed according to an embodiment.

Referring to FIG. 9, a first graph 910 according to an embodiment is a radiation efficiency graph of an antenna including the first conductive member 311 and the second conductive member 312 when the wireless communication circuit 323 feeds power to the first conductive member 311 in a case in which the plurality of conductive regions 820 are not formed. A second graph 920 is a radiation efficiency graph of an antenna including the first conductive member 311 and the second conductive member 312 when the wireless communication circuit 323 feeds power to the first conductive member 311 in a case in which the plurality of conductive regions 820 are formed (e.g., FIG. 8B).

According to an embodiment, a third graph 930 is a reflection coefficient graph of signals radiated by an antenna including the first conductive member 311 and the second conductive member 312 when the wireless communication circuit 323 feeds power to the first conductive member 311 in a case in which the plurality of conductive regions 820 are not formed. A fourth graph 940 is a reflection coefficient graph of an antenna including the first conductive member 311 and the second conductive member 312 when the wireless communication circuit 323 feeds power to the first conductive member 311 in a case in which the plurality of conductive regions 820 are formed.

Comparing the first graph 910 and the second graph 920, it may be confirmed that the second graph 920 is shifted to a relatively higher frequency band compared to the first graph 910. For example, compared to a first point 911 having the highest radiation efficiency value in the first graph 910, a second point 912 having the highest radiation efficiency value in the second graph 920 is shown in a relatively higher frequency band.

Comparing the third graph 930 and the fourth graph 940, it may be confirmed that the fourth graph 940 is shifted to a relatively higher frequency band compared to the third graph 930.

According to an embodiment, when the plurality of conductive regions 820 are formed, an electrical path 801 may be formed in the first conductive member 311, the second conductive member 312, the first conductive region 821, and the second conductive region 822, and the electrical path 801 may be relatively shorter than the electrical path 520 of FIG. 5A. Accordingly, when the plurality of conductive regions 820 are formed, an operating frequency of an antenna including the first conductive member 311 and the second conductive member 312 may be shifted to a relatively higher frequency compared to a case in which the plurality of conductive regions 820 are not formed.

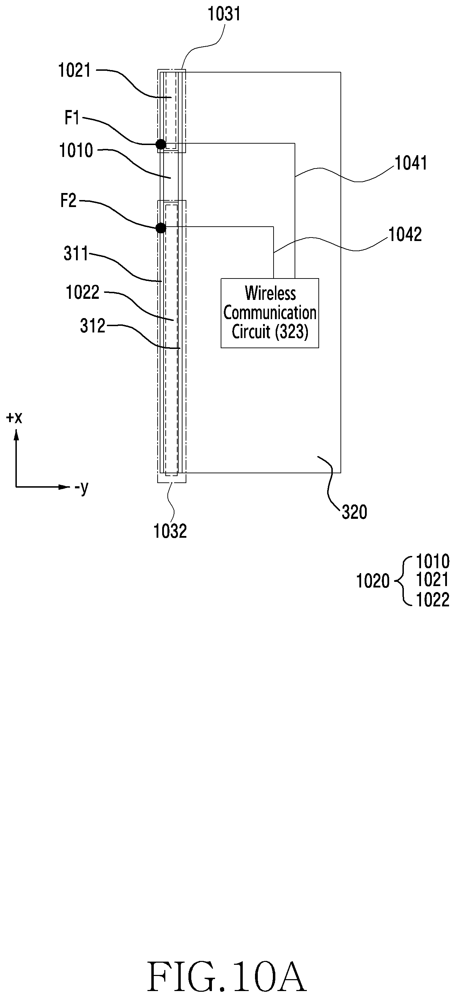

FIG. 10A is a view illustrating a case in which a space between a first conductive member and a second conductive member is divided into a plurality of spaces according to an embodiment.

Referring to FIG. 10A, a first region 1020 of the printed circuit board 320 may be disposed or formed between the first conductive member 311 and the second conductive member 312 according to an embodiment.

According to an embodiment, the first region 1020 may include a region that does not include a conductive material (or a region including only a non-conductive material) and a region including a conductive material. For example, the first region 1020 may include a first sub-region 1021 and a second sub-region 1022 that do not include a conductive material. For example, the first region 1020 may include a first conductive region 1010 including a conductive material.

For example, the first sub-region 1021 and the second sub-region 1022 may be regions formed by removing a ground layer of the printed circuit board 320. The first conductive region 1010 may be a region including the ground layer of the printed circuit board 320.

According to an embodiment, the first conductive region 1010 may be disposed or formed between the first sub-region 1021 and the second sub-region 1022. For example, the first sub-region 1021 may be disposed in a fifth direction (e.g., the +x direction) with respect to the first conductive region 1010. For example, the second sub-region 1022 may be disposed in a sixth direction (e.g., the -x direction) with respect to the first conductive region 1010.

According to an embodiment, the first conductive region 1010 may electrically connect the first conductive member 311 and the second conductive member 312. According to an embodiment, as the first conductive region 1010 is formed, the first region 1020 between the first conductive member 311 and the second conductive member 312 may be divided into a plurality of slots. For example, when the first conductive region 1010 is not formed, the first region 1020 may define a single slot. In this case, an electrical path 520 may be formed in the first conductive member 311 and the second conductive member 312 surrounding the first region 1020 as illustrated in FIG. 5A.

When the first conductive region 1010 according to an embodiment is formed and the first conductive region 1010 electrically connects the first conductive member 311 and the second conductive member 312, the first region 1020 between the first conductive member 311 and the second conductive member 312 may be divided into a plurality of slots by the first conductive region 1010. For example, the first region 1020 may be divided into a first slot corresponding to the first sub-region 1021 located in a fifth direction (e.g., the +x direction) with respect to the first conductive region 1010 and a second slot corresponding to the second sub-region 1022 located in a sixth direction (e.g., the -x direction) with respect to the first conductive region 1010.

In FIG. 10A of the disclosure, unlike the embodiment of FIG. 5A, as the first sub-region 1021 and the second sub-region 1022 (or the first slot and the second slot) are formed between the first conductive member 311 and the second conductive member 312, the electronic device 101 may transmit and/or receive signals in multiple frequency bands. Hereinafter, when the first sub-region 1021 and the second sub-region 1022 (or the first slot and the second slot) are formed between the first conductive member 311 and the second conductive member 312, the wireless communication circuit 323 may implement multiple frequency bands (e.g., a fourth frequency band or a fifth frequency band) by feeding power to the first conductive member 311.

According to an embodiment, the wireless communication circuit 323 may feed power to a first point F1 of the first conductive member 311 through a first conductive path 1041. For example, the first conductive path 1041 may be electrically connected to the first conductive member 311 via the first sub-region 1021. The wireless communication circuit 323 may feed power to the first point F1 of the first conductive member 311 via the first conductive path 1041 to transmit and/or receive RF signals in the fourth frequency band. For example, the fourth frequency band may be a frequency band relatively higher than at least one frequency band (e.g., the first frequency band), which is a frequency band of RF signals transmitted and/or received by the wireless communication circuit 323 via the first conductive member 311 and the second conductive member 312 in FIG. 5A.

According to an embodiment, the wireless communication circuit 323 may feed power to a second point F2 of the first conductive member 311 through a second conductive path 1042. For example, the second conductive path 1042 may be electrically connected to the first conductive member 311 via the second sub-region 1022. The wireless communication circuit 323 may feed power to the second point F2 of the first conductive member 311 via the second conductive path 1042 to transmit and/or receive RF signals in the fifth frequency band. For example, the fifth frequency band may be a frequency band relatively higher than at least one frequency band (e.g., the first frequency band), which is a frequency band of RF signals transmitted and/or received by the wireless communication circuit 323 in FIG. 5A.

According to an embodiment, as the wireless communication circuit 323 feeds power to the first point F1 of the first conductive member 311, a first electrical path 1041 may be formed in the first conductive member 311 and the second conductive member 312. The wireless communication circuit 323 may transmit and/or receive RF signals in the fourth frequency band based on the first electrical path 1041.

According to an embodiment, as the wireless communication circuit 323 feeds power to the second point F2 of the first conductive member 311, a second electrical path 1042 may be formed in the first conductive member 311 and the second conductive member 312. The wireless communication circuit 323 may transmit and/or receive RF signals in the fifth frequency band based on the second electrical path 1042.

According to an embodiment, the first electrical path 1041 may have an electrical length relatively shorter than the electrical path 520 of FIG. 5A, and accordingly the fourth frequency band based on the first electrical path 1041 may be a frequency band relatively higher than the first frequency band based on the electrical path 520. As another example, the second electrical path 1042 may have an electrical length relatively shorter than the electrical path 520 of FIG. 5A, and accordingly the fifth frequency band based on the second electrical path 1042 may be a frequency band relatively higher than the first frequency band based on the electrical path 520.

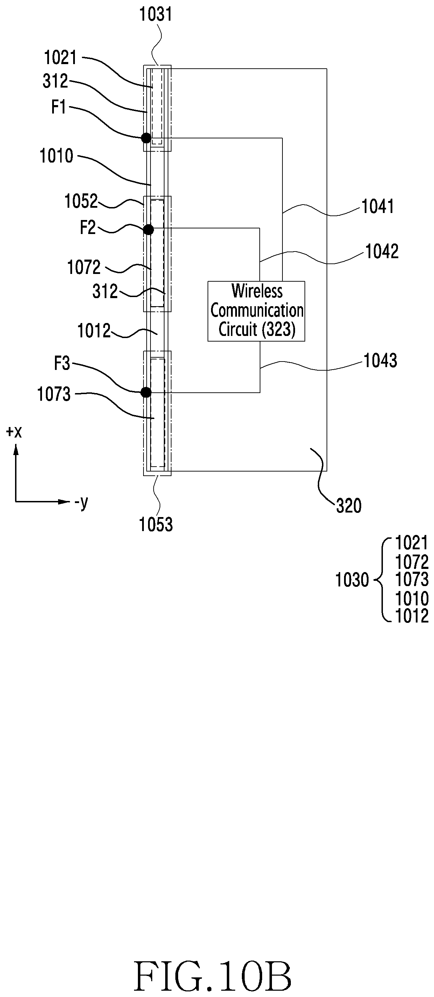

FIG. 10B is a view illustrating a case in which a space between a first conductive member and a second conductive member is divided into a plurality of spaces according to an embodiment.

Referring to FIG. 10B, a first region 1030 of the printed circuit board 320 may be disposed or formed between the first conductive member 311 and the second conductive member 312 according to an embodiment. The first region 1030 of FIG. 10B of the disclosure may correspond to the first region 321 of FIG. 3 unless inconsistent.

According to an embodiment, the first region 1030 may include a region including a conductive material and a region including a non-conductive material. For example, the first region 1030 may include a first conductive region 1010 and/or a second conductive region 1012 including a conductive material. For example, the first region 1030 may include a first sub-region 1031, a second sub-region 1032, and/or a third sub-region 1073 that do not include a conductive material. As another example, the first region 1030 may include a first sub-region 1031, a second sub-region 1032, and/or a third sub-region 1073 that include only a non-conductive material.

For example, the first conductive region 1010 and/or the second conductive region 1012 may be regions in which the ground layer of the printed circuit board 320 is not removed (e.g., ground fill regions). For example, the first sub-region 1031, the second sub-region 1032, and/or the third sub-region 1073 may be regions formed by removing the ground layer of the printed circuit board 320 (e.g., fill cut regions).

According to an embodiment, the first conductive region 1010 may be disposed or formed between the first sub-region 1021 and the second sub-region 1072. For example, the first sub-region 1021 may be disposed in a fifth direction (e.g., the +x direction) with respect to the first conductive region 1010. For example, the second sub-region 1072 may be disposed in a sixth direction (e.g., the -x direction) with respect to the first conductive region 1010.

According to an embodiment, the second conductive region 1012 may be disposed or formed between the second sub-region 1072 and the third sub-region 1073. For example, the second sub-region 1072 may be disposed in the fifth direction (e.g., the +x direction) with respect to the second conductive region 1012. For example, the third sub-region 1073 may be disposed in the sixth direction (e.g., the -x direction) with respect to the second conductive region 1012.

According to an embodiment, the first conductive region 1010 may electrically connect the first conductive member 311 and the second conductive member 312. As another example, the second conductive region 1012 may electrically connect the first conductive member 311 and the second conductive member 312.

According to an embodiment, as the first conductive region 1010 electrically connects the first conductive member 311 and the second conductive member 312, the first region 1030 between the first conductive member 311 and the second conductive member 312 may be divided into a plurality of slots. For example, when the first conductive region 1010 and the second conductive region 1012 are not formed, the first region 1030 may define a single slot.

According to an embodiment, as the first conductive region 1010 and the second conductive region 1012 electrically connect the first conductive member 311 and the second conductive member 312, the first region 1030 between the first conductive member 311 and the second conductive member 312 may be divided based on the first conductive region 1010 and the second conductive region 1012. For example, the first region 1030 may be divided into a first slot corresponding to the first sub-region 1021 located in a fifth direction (e.g., the +x direction) with respect to the first conductive region 1010 and a second slot corresponding to the second sub-region 1072 located in a sixth direction (e.g., the -x direction) with respect to the first conductive region 1010. For example, the first region 1030 may be divided into a second slot corresponding to the second sub-region 1072 located in the fifth direction (e.g., the +x direction) with respect to the second conductive region 1012 and a third slot corresponding to the third sub-region 1073 located in the sixth direction (e.g., the -x direction) with respect to the second conductive region 1012.

In FIG. 10B of the disclosure, unlike the embodiment of FIG. 5A, as the first sub-region 1021, the second sub-region 1072, and the third sub-region 1073 (or the first slot, the second slot, and the third slot) are formed between the first conductive member 311 and the second conductive member 312, the electronic device 101 may transmit and/or receive signals in multiple frequency bands. Hereinafter, when the first sub-region 1021, the second sub-region 1072, and the third sub-region 1073 are formed between the first conductive member 311 and the second conductive member 312, the wireless communication circuit 323 may implement multiple frequency bands (e.g., a fourth frequency band, a sixth frequency band, and a seventh frequency band) by feeding power to the first conductive member 311.

According to an embodiment, the wireless communication circuit 323 may feed power to a first point F1 of the first conductive member 311 through a first conductive path 1041. For example, the first conductive path 1041 may be electrically connected to the first conductive member 311 via the first sub-region 1021 including a non-conductive material. The wireless communication circuit 323 may feed power to the first conductive member 311 through the first conductive path 1041 to transmit and/or receive RF signals in the fourth frequency band. For example, the fourth frequency band may be a frequency band relatively higher than the first frequency band, which is a frequency band of RF signals transmitted and/or received by the wireless communication circuit 323 through the first conductive member 311 and the second conductive member 312 in FIG. 5A.

According to an embodiment, the wireless communication circuit 323 may feed power to a second point F2 of the first conductive member 311 through a second conductive path 1042. For example, the second conductive path 1042 may be electrically connected to the first conductive member 311 through the second sub-region 1072 including a non-conductive material. The wireless communication circuit 323 may feed power to the first conductive member 311 through the second conductive path 1042 to transmit and/or receive RF signals in the sixth frequency band. For example, the sixth frequency band may be a frequency band relatively higher than the first frequency band, which is a frequency band of RF signals transmitted and/or received by the wireless communication circuit 323 in FIG. 5A.

According to an embodiment, the wireless communication circuit 323 may feed power to a third point F3 of the first conductive member 311 through a third conductive path 1043. For example, the third conductive path 1043 may be electrically connected to the first conductive member 311 through the third sub-region 1073. The wireless communication circuit 323 may feed power to the first conductive member 311 through the third conductive path 1043 to transmit and/or receive RF signals in a seventh frequency band. For example, the seventh frequency band may be a frequency band relatively higher than the first frequency band, which is a frequency band of RF signals transmitted and/or received by the wireless communication circuit 323 in FIG. 5A.

According to an embodiment, as the wireless communication circuit 323 feeds power to the first point F1 of the first conductive member 311, a first electrical path 1041 may be formed in the first conductive member 311 and the second conductive member 312. The wireless communication circuit 323 may transmit and/or receive RF signals in the fourth frequency band based on (or using) the first electrical path 1041.

According to an embodiment, as the wireless communication circuit 323 feeds power to the second point F2 of the first conductive member 311, a second electrical path 1052 may be formed in the first conductive member 311 and the second conductive member 312. The wireless communication circuit 323 may transmit and/or receive RF signals in the sixth frequency band based on the second electrical path 1052.

According to an embodiment, as the wireless communication circuit 323 feeds power to the third point F3 of the first conductive member 311, a third electrical path 1053 may be formed in the first conductive member 311 and the second conductive member 312. The wireless communication circuit 323 may transmit and/or receive RF signals in the seventh frequency band based on the third electrical path 1053.

According to an embodiment, the first electrical path 1041 may have an electrical length relatively shorter than the electrical path 520 of FIG. 5A, and accordingly the fourth frequency band based on the first electrical path 1041 may be a frequency band relatively higher than the first frequency band based on the electrical path 520. As another example, the second electrical path 1052 may have an electrical length relatively shorter than the electrical path 520 of FIG. 5A, and accordingly the sixth frequency band based on the second electrical path 1052 may be a frequency band relatively higher than the first frequency band based on the electrical path 520. As another example, the third electrical path 1053 may have an electrical length relatively shorter than the electrical path 520 of FIG. 5A, and accordingly the seventh frequency band based on the third electrical path 1053 may be a frequency band relatively higher than the first frequency band based on the electrical path 520.

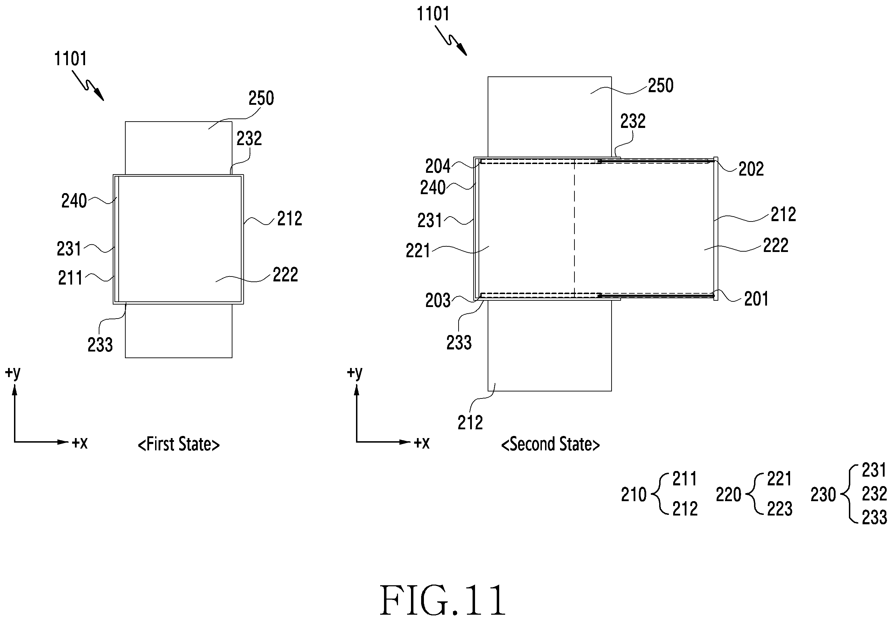

FIG. 11 is a view illustrating a first state and a second state of an electronic device according to an embodiment.

Referring to FIG. 11, an electronic device 1101 (e.g., a wearable device) according to an embodiment may include a housing 210, a display 220, a non-conductive member 240, and/or a fastening member 250.

Unlike the electronic device 101 of FIG. 2, the housing 210 of FIG. 11 of the disclosure illustrates an embodiment in which the second housing 212 is coupled to the fastening member 250 so as to be movable in a direction perpendicular to the fastening member 250. For example, the second housing 212 of FIG. 11 may move in a direction (e.g., the x-axis direction) perpendicular to a direction in which the fastening member 250 is arranged (e.g., the y-axis direction). On the other hand, the second housing 212 of FIG. 2 may move in a direction parallel (e.g., the y-axis direction) to the direction in which the fastening member 250 is arranged (e.g., the y-axis direction).

According to an embodiment, the housing 210 forming at least a portion of an exterior of the electronic device 1101 may include a first housing 211 and/or a second housing 212. For example, the first housing 211 may be coupled to the fastening member 250, and the first housing 211 may be a housing fixed to the fastening member 250. For example, the second housing 212 may be a housing movable relative to the first housing 211 in a fifth direction (e.g., the +x direction) or a sixth direction (e.g., the -x direction). In an example, the fifth direction (e.g., the +x direction) may be a direction in which the second housing 212 moves away from the first housing 211, and the sixth direction (e.g., the -x direction) may be a direction in which the second housing 212 moves closer to the first housing 211.

According to an embodiment, the second housing 212 may include a first rail 201 and/or a second rail 202, and the second housing 212 may move closer to or farther from the first housing 211 via a first rail 201 and/or a second rail 202.

For example, the first rail 201 of the second housing 212 may move while being in contact with a third rail 203 of the first housing 211, and the first rail 201 of the second housing 212 may move while being in contact with a fourth rail 204 of the first housing 211. In an example, a user may physically hold the second housing 212 and move the second housing 212 in the fifth direction (e.g., the +x direction), and the second housing 212 may move in the fifth direction (e.g., the +x direction) as the first rail 201 and the second rail 202 move in the fifth direction (e.g., the +x direction). As another example, a user may physically hold the second housing 212 and move the second housing 212 in the sixth direction (e.g., the -x direction), and the second housing 212 may move in the sixth direction (e.g., the -x direction) as the first rail 201 and the second rail 202 move in the sixth direction (e.g., the -x direction).

According to an embodiment, the display 220 may include a first display portion 221 and/or a second display portion 222. For example, the first display portion 221 may include a portion slid into or slid out from the interior of the first housing 211, and the second display portion 222 may be a portion disposed on the front surface 200 of the electronic device 101 regardless of movement of the second housing 212.

For example, the first display portion 221 may be a portion slid into the interior of the first housing 211 when the electronic device 101 is in a first state, and the second display portion 222 may be a portion disposed outside the first housing 211 when the electronic device 101 is in the first state.

According to an embodiment, the display 220 may be a flexible display. For example, the display 220 may include the first display portion 221 including a portion that is bent or curved.

According to an embodiment, the first housing 211 may include a side surface member 230 and/or a rear surface cover (e.g., the rear surface cover 302 of FIG. 3). For example, the side surface member 230 may include a first side surface portion 231, a second side surface portion 232, and/or a third side surface portion 233. For example, the second side surface portion 232 may be substantially perpendicular to the first side surface portion 231. For example, the third side surface portion 233 may be substantially perpendicular to the first side surface portion 231 and substantially parallel to the second side surface portion 232.

According to an embodiment, the side surface member 230 included in the first housing 211 may include a conductive material and/or a non-conductive material. For example, the entirety of the first side surface portion 231 of the side surface member 230 may include a conductive material. For example, the first side surface portion 231 of the side surface member 230 may include a conductive material and a non-conductive material. For example, the entirety of the first side surface portion 231 of the side surface member 230 may include a non-conductive material.

According to an embodiment, the non-conductive member 240 (e.g., rubber or glass) may be disposed on the front surface 200 of the electronic device 101. For example, the non-conductive member 240 may be disposed on the front surface 200 of the electronic device 101 so as to be adjacent to the first side surface portion 231.

According to an embodiment, when the first display portion 221 of the display 220 is slid into the interior of the first housing 211 or slid out from the interior of the first housing 211, the non-conductive member 240 may reduce or prevent foreign substances located outside the electronic device 101 from being introduced into the electronic device 101.

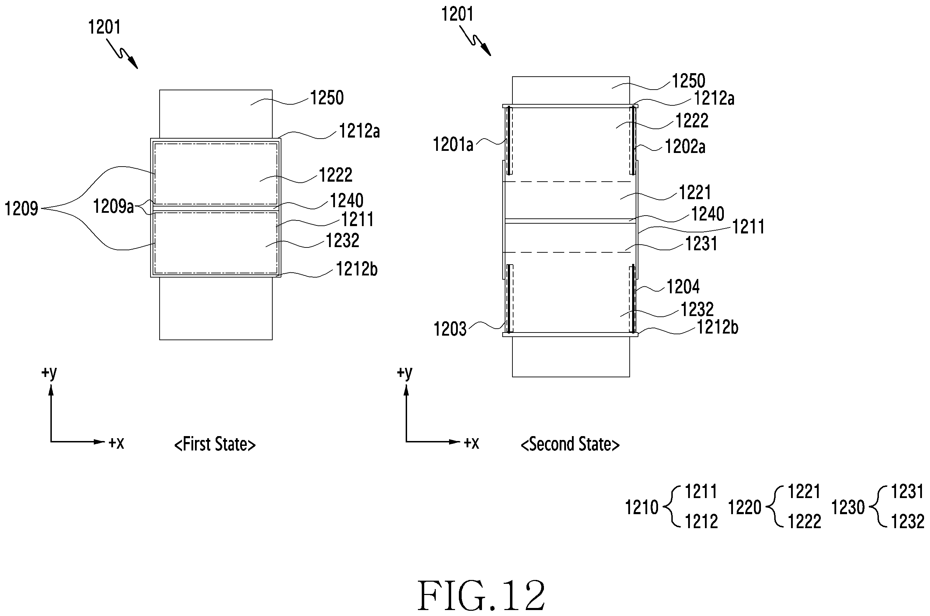

FIG. 12 is a view illustrating a first state and a second state of an electronic device according to an embodiment.

Referring to FIG. 12, an electronic device 1201 (e.g., a wearable device) according to an embodiment may include a housing 1210, a display 1220, a non-conductive material 1240, and/or a fastening member 1250.

According to an embodiment, the housing 1210 forming at least a portion of an exterior of the electronic device 1201 may include a first housing 1211 and/or a second housing 1212. For example, the first housing 1211 may be coupled to the fastening member 1250 and may be a housing fixed to the fastening member 1250.

For example, the second housing 1212 may include a first part 1212a movable in a second direction (e.g., the +y direction) with respect to the first housing 1211 and a second part 1212b movable in a first direction (e.g., the -y direction) with respect to the first housing 1211. In an example, the first direction (e.g., the -y direction) and the second direction (e.g., the +y direction) may be parallel to a direction in which the fastening members 1250 are arranged (e.g., the y-axis direction).

According to an embodiment, the first part 1212a of the second housing 1212 may be connected to the first rail 1201a and the second rail 1202a, and the second part 1212b may be connected to the third rail 1203 and the fourth rail 1204.

According to an embodiment, the first part 1212a of the second housing 1212 may move closer to or farther from the first housing 1211 via the first rail 1201a and the second rail 1202a. For example, in the first state, a user of the electronic device may physically pull the first part 1212a in the second direction (e.g., the +y direction), and accordingly the first rail 1201a and the second rail 1202a of the second housing 1212 may move in the second direction (e.g., the +y direction) while being in contact with the rails disposed in the first housing 1211. As another example, in the second state, the user may push the first part 1212a in the first direction (e.g., the -y direction), and accordingly the first rail 1201a and the second rail 1202a of the second housing 1212 may move in the first direction (e.g., the -y direction) while being in contact with the rails disposed in the first housing 1211.

According to an embodiment, the second part 1212b of the second housing 1212 may move closer to or farther from the first housing 1211 via the third rail 1203 and the fourth rail 1204. For example, the user may physically pull the second part 1212b in the first direction (e.g., the -y direction), and accordingly the third rail 1203 and the fourth rail 1204 of the second housing 1212 may move in the first direction (e.g., the -y direction) while being in contact with the rails disposed in the first housing 1211. As another example, in the second state, the user may push the second part 1212b in the second direction (e.g., the +y direction), and accordingly the third rail 1203 and the fourth rail 1204 of the second housing 1212 may move in the second direction (e.g., the +y direction) while being in contact with the rails disposed in the first housing 1211.

According to an embodiment, the electronic device 101 may have a first state and a second state. For example, the first state may be a state in which the second housing 1212 is in contact with the first housing 1211, and the second state may be a state in which the second housing 1212 is spaced apart from the first housing by a predetermined distance (e.g., a maximum movable distance). For example, in the first state, the first part 1212a and the second part 1212b of the second housing 1212 may be in contact with the first housing 1211. When the state changes from the first state to the second state, the first rail 1201a and the second rail 1202a may be maximally extended so that the first part 1212a may be spaced apart from the first housing 1211 by the maximum distance. In the second state, the third rail 1203 and the fourth rail 1204 may be maximally extended so that the second part 1212b may be spaced apart from the first housing 1211 by the maximum distance. For example, in the first state, the first housing 1211 may be connected to the first part 1212a via the first rail 1201a and the second rail 1202a. In this case, the first housing 121 1 and the first part 1212a may be in direct contact with each other. In addition, in the first state, the first housing 1211 may be connected to the second part 1212b via the third rail 1203 and the fourth rail 1204. In this case, the first housing 1211 and the second part 1212b may be in direct contact with each other.

For example, in the second state, the first housing 1211 and the first part 1212a may be connected via the first rail 1201a and the second rail 1202a, but the first housing 1211 and the first part 1212a may not be in direct contact with each other. In the second state, the first housing 1211 and the second part 1212b may be connected via the third rail 1203 and the fourth rail 1204, but the first housing 1211 and the second part 1212b may not be in direct contact with each other.

For example, the first state may be a state in which the second housing 1212 is as close as possible to the first housing 1211, and the second state may be a state in which the second housing 1212 is as far as possible from the first housing 1211.

According to an embodiment, the electronic device 101 may have a first state, a second state, and/or an intermediate state. For example, the intermediate state may be a state between the first state and the second state. For example, the intermediate state may be referred to as a state of the electronic device 101 while the electronic device 101 changes from the first state to the second state.

According to an embodiment, the electronic device 1201 may include the first display 1220 and/or the second display 1230. For example, the first display 1220 may include a first display portion 1221 including a portion that is slid into the interior of the first housing 1211 or slid out from the interior of the first housing 1211, and a second display portion 1222 disposed on the front surface of the electronic device 1201 regardless of movement of the first part 1212a.

For example, the second display 1230 may include a third display portion 1231 including a portion that is slid into the interior of the first housing 1211 or slid out from the interior of the first housing 1211, and a fourth display portion 1232 disposed on the front surface of the electronic device 101 regardless of movement of the second part 1212b.

For example, when the state changes from the first state to the second state, the first display portion 1221 may be slid out from the interior of the first housing 1211 as the first part 1212a moves in the second direction (e.g., the +y direction). When the state changes from the second state to the first state, the first display portion 1221 may be slid into the interior of the first housing 1211 as the first part 1212a moves in the first direction (e.g., the -y direction). For example, the first display portion 1221 may be configured to be movable.

For example, when the state changes from the first state to the second state, the third display portion 1231 may be slid out from the interior of the first housing 1211 as the second part 1212b moves in the first direction (e.g., the -y direction). When the state changes from the second state to the first state, the third display portion 1231 may be slid into the interior of the first housing 1211 as the second part 1212b moves in the second direction (e.g., the +y direction). For example, the third display portion 1231 may be configured to be movable.

According to an embodiment, the first display 1220 and/or the second display 1230 may be a flexible display. For example, the first display 1220 may include a first display portion 1221 including a portion that is bent or curved. For example, the second display 1230 may include a third display portion 1231 including a portion that is bent or curved.

According to an embodiment, a non-conductive material 1240 (e.g., rubber or glass) may be disposed on the front surface of the electronic device 101. For example, the non-conductive material 1240 may be disposed between the first display 1220 and the second display 1230. For example, the non-conductive material 1240 may be located at a center of the first housing 1211. For example, the non-conductive material 1240 may be formed to extend in a predetermined direction (e.g., the x-axis direction) and may be disposed within the first housing 1211 so as to form the front surface of the electronic device 1201.

According to an embodiment, the non-conductive material 1240 may be disposed along one side 1209a of a region 1209 in which the displays are exposed.

According to an embodiment, when the first display portion 1221 of the first display 1220 is slid into the interior of the first housing 1211 or slid out from the interior of the first housing 1211, the non-conductive material 1240 may reduce or prevent foreign substances located outside the electronic device 1201 from being introduced into the electronic device 1201. As another example, when the third display portion 1223 of the second display 1230 is slid into the interior of the first housing 1211 or slid out from the interior of the first housing 1211, the non-conductive material 1240 may reduce or prevent foreign substances located outside the electronic device 1201 from being introduced into the electronic device 1201.

In FIG. 12 of the disclosure, movement of the second housing 1212, movement of the first display 1220, or movement of the second display 1230 has been described as being performed by a physical force of a user, but this is merely an example. For example, the second housing 1212, the first display 1220, and/or the second display 1230 may be moved by a motor or a roller included in the electronic device 101. For example, the electronic device 1201 may identify a user input (e.g., an input to the first display 1220 or a physical input to a key button), and the electronic device 1201 may move the second housing 1212, the first display 1220, and/or the second display 1230 in the first direction (e.g., the -y direction) or the second direction (e.g., the +y direction) through the roller based on the user input. For example, the first display 1220 may be moved in the first direction (e.g., the -y direction) or the second direction (e.g., the +y direction). For example, the second display 1230 may be moved in the first direction (e.g., the -y direction) or the second direction (e.g., the +y direction).

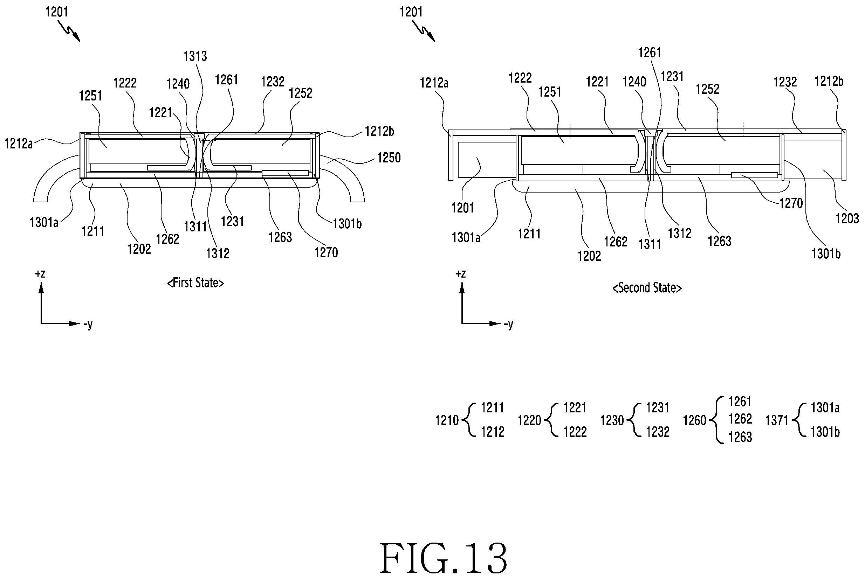

FIG. 13 illustrates a cross-sectional view of an electronic device according to an embodiment.

Referring to FIG. 13, the electronic device 1201 according to an embodiment may include a first conductive member 1311, a second conductive member 1312, a printed circuit board 1260, a wireless communication circuit 1270, a first battery 1251, and/or a second battery 1252.

According to an embodiment, the first housing 1211 may include a rear surface cover 1202. For example, the rear surface cover 1202 may form a rear surface of the electronic device 1201 and may come into contact with a user's body (e.g., a wrist) when the electronic device 1201 is mounted on the user's body (e.g., the wrist). For example, the rear surface cover 1202 may include a non-conductive material. However, a material included in the rear surface cover 1202 is not limited to a non-conductive material, and the rear surface cover 1202 may include a conductive material.

According to an embodiment, the printed circuit board 1260 may include a first region 1261, a second region 1262, and/or a third region 1263. For example, the first region 1261 may not include a conductive material, and the second region 1262 and the third region 1263 may include a conductive material. For example, the first region 1261 may be located between the second region 1262 and the third region 1263. For example, the second region 1262 may be located in a second direction (e.g., the +y direction) with respect to the first region 1261. For example, the third region 1263 may be located in a third direction (e.g., the -y direction) with respect to the first region 1261.

According to an embodiment, a fastening member 1250 (e.g., a strap) may be coupled to the rear surface cover 1202. For example, the fastening member 1250 may be detachably coupled to the rear surface cover 1202.

According to an embodiment, the first conductive member 1311 and/or the second conductive member 1312 may be disposed within the first housing 1211. For example, the first conductive member 1311 may be disposed between the first display 1220 and the second display 1230. For example, the second conductive member 1312 may be disposed between the first display 1220 and the second display 1230.

For example, the first conductive member 1311 and the second conductive member 1312 may be located at a center of the first housing 1211. For example, the first conductive member 1311 and the second conductive member 1312 may extend lengthwise along a predetermined axis (e.g., the x-axis) and may be disposed between the first battery 1251 and the second battery 1252.

According to an embodiment, the second conductive member 1312 may be disposed adjacent to the first conductive member 1311. For example, the second conductive member 1312 may be disposed adjacent to the first conductive member 1311 within a distance that enables electromagnetic connection with the first conductive member 1311. For example, the second conductive member 1312 may be disposed adjacent to the first conductive member 1311 within a distance that enables coupling connection with the first conductive member 311. For example, the second conductive member 1312 may be arranged in parallel with the first conductive member 1311. For example, the first conductive member 1311 and the second conductive member 1312 may be arranged in parallel along a predetermined axis (e.g., the x-axis).

According to an embodiment, the first conductive member 1311 and/or the second conductive member 1312 may have various shapes. For example, the first conductive member 1311 and/or the second conductive member 1312 may have a plate shape.

According to an embodiment, the first conductive member 1311 and/or the second conductive member 1312 may support the non-conductive material 1240 (e.g., rubber or glass). For example, the first conductive member 1311 may be disposed in a third direction (e.g., the -z direction) with respect to the non-conductive material 1240 to support the non-conductive material 1240. For example, the second conductive member 1312 may be disposed in the third direction (e.g., the -z direction) with respect to the non-conductive material 1240 to support the non-conductive material 1240. For example, the first conductive member 1311 may be disposed between the non-conductive material 1240 and the rear surface cover 1302, and the second conductive member 1312 may be disposed between the non-conductive material 1240 and the rear surface cover 1302.

For example, the first conductive member 1311 may be disposed between the non-conductive material 1240 and the first region 1261. For example, the second conductive member 1312 may be disposed between the non-conductive material 1240 and the second region 1262.

According to an embodiment, a dielectric material 1313 (e.g., an injection-molded member or air) having a predetermined dielectric constant may be disposed between the first conductive member 1311 and the second conductive member 1312. For example, the dielectric constant of the dielectric material 1313 may be determined based on a frequency band in which the wireless communication circuit 1270 is to transmit and/or receive signals based on the first conductive member 1311 and the second conductive member 1312. For example, the dielectric constant of the dielectric material 313 may be based on the frequency band.

According to an embodiment, the printed circuit board 1260 may provide electrical connection paths for various components in the electronic device 1201 or may provide a space in which various components are disposed. For example, a processor 120 may be disposed on the second region 1262 of the printed circuit board 1260, and the printed circuit board 1260 may provide electrical paths that electrically connect the power management module 188 to the first battery 1251 and the second battery 1252.

As another example, the wireless communication circuit 1270 may be disposed on or within the third region 1263, and the printed circuit board 1260 may provide electrical paths that electrically connect the wireless communication circuit 1270 to the first conductive member 1311 and/or the second conductive member 1312.

According to an embodiment, the first conductive member 1311 and the second conductive member 1312 may be disposed on the printed circuit board 1260. For example, the first conductive member 1311 may be disposed on the first region 1261 of the printed circuit board 1260. For example, the second conductive member 1312 may be disposed on the second region 1262 of the printed circuit board 1260.

According to an embodiment, the printed circuit board 1260 may include a first region 1261 located between the first conductive member 1311 and the second conductive member 1312. For example, when viewed in the third direction (e.g., the -z direction), the first region 1261 may be disposed between the first conductive member 1311 and the second conductive member 1312. For example, when viewed in a direction toward an interior of the electronic device 1201 (e.g., the -z direction), the first region 1261 may be disposed between the first conductive member 1311 and the second conductive member 1312.

According to an embodiment, the first region 1261 of the printed circuit board 1260 may not include a conductive material. For example, at least a portion of the first region 1261 may be formed of a non-conductive material. For example, the first region 1261 may be a non-conductive region formed by removing a metal layer (e.g., a ground layer) of the printed circuit board 1260. For example, the first region 1261 may be a peel-cut region or a cutting region formed by cutting a metal layer of the printed circuit board 1260.

According to an embodiment, the wireless communication circuit 1270 may be disposed on the printed circuit board 1260 or within the printed circuit board 1260. The wireless communication circuit 1270 of FIG. 13 of the disclosure may correspond to the wireless communication circuit 323 of FIG. 3.

According to an embodiment, the electronic device 1201 may include an inner housing 1371. For example, the inner housing 1371 may include a first housing portion 1301a and/or a second housing portion 1301b.

According to an embodiment, the inner housing 1371 may reduce or prevent foreign substances outside the electronic device 1201 from being introduced into the electronic device 1201 while the second housing 1212 moves.

For example, the second part 1212b of the second housing 1212 may move in a first direction (e.g., the -y direction) based on a user input or a physical force of a user. In this case, as the second housing portion 1301b is fixed in position, the interior and the exterior of the electronic device 1201 may be blocked from each other. For example, even when the second part 1212b moves in the first direction (e.g., the -y direction), the second housing portion 1301b remains fixed, thereby reducing or preventing foreign substances located outside from being introduced into the electronic device 1201.

For example, the first part 1212a of the second housing 1212 may move in a second direction (e.g., the +y direction) based on a user input or a physical force. In this case, as the second housing portion 1301a is fixed in position, the interior and the exterior of the electronic device 1201 may be blocked from each other. For example, even when the first part 1212a moves in the second direction (e.g., the +y direction), the second housing portion 1301a remains fixed, thereby reducing or preventing foreign substances located outside from being introduced into the electronic device 1201.

In the disclosure, the printed circuit board 1260 has been described as including the second region 1262 and the third region 1263 with respect to the first region 1261, but this is merely an example. For example, the electronic device 1201 may include a plurality of printed circuit boards instead of a single printed circuit board 1260, and may include a first printed circuit board corresponding to the second region 1262 and a second printed circuit board corresponding to the third region 1263 with respect to the first region 1261.

The term "inner housing 1371" of the disclosure is a term used to describe a housing distinguished from the first housing and the second housing, and may be replaced with another term. For example, the term "inner housing 1371" may be replaced with the term "third housing," "frame," or "inner frame."

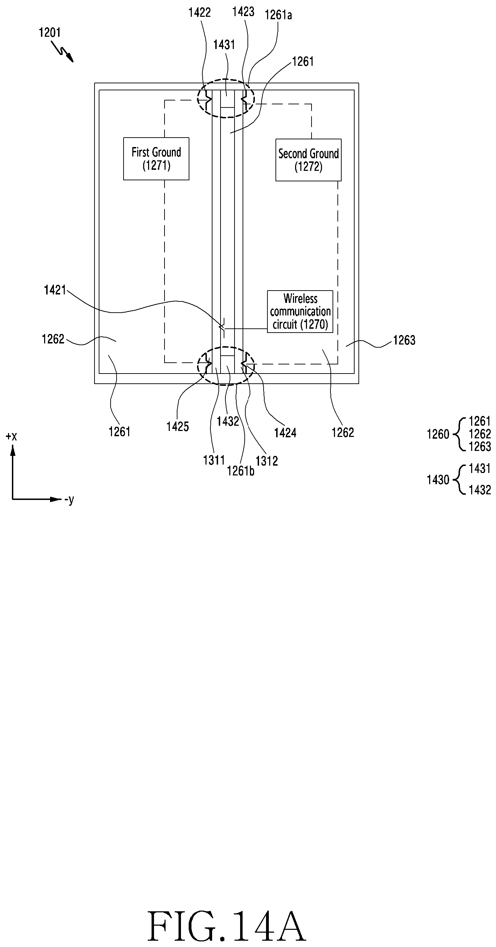

FIG. 14A is a view illustrating conductive regions formed in a first region between the first conductive member and the second conductive member according to an embodiment.

Referring to FIG. 14A, a plurality of conductive regions 1430 may be formed or disposed in the first region 1261 according to an embodiment. For example, the printed circuit board 1260 may include the first region 1261 disposed between the first conductive member 1311 and the second conductive member 1312. A first conductive region 1431 may be formed at a first end 1261a of the first region 1261, and a second conductive region 1432 may be formed at a second end 1261b of the second region 1262.

According to an embodiment, the first conductive region 1431 and/or the second conductive region 1432 may be referred to as a portion of a region including a conductive layer of the printed circuit board 1260.

According to an embodiment, the first conductive region 1431 and the second conductive region 1432 may electrically connect the first conductive member 1311 and the second conductive member 1312. For example, the first conductive region 1431 may electrically connect the first conductive member 1311 and the second conductive member 1312 at the first end 1261a of the first region 1261. For example, the second conductive region 1432 may electrically connect the first conductive member 1311 and the second conductive member 1312 at the second end 1261b of the first region 1261.

According to an embodiment, a wireless communication circuit 1270 may feed power to the first conductive member 1311 through a first conductive connection member 1421. The wireless communication circuit 1270 may transmit and/or receive RF signals in a predetermined frequency band based on an electrical path formed in the first conductive member 1311, the second conductive member 1312, the first conductive region 1431, and the second conductive region 1432.

According to an embodiment, the second region 1262 of the printed circuit board 1260 may include a first ground 1271. The first ground 1271 may be electrically connected to the first conductive member 1311. For example, the first ground 1271 may be electrically connected to the first conductive member 1311 via a second conductive connection member 1422. For example, the first ground 1271 may be electrically connected to the first conductive member 1311 via a fifth conductive connection member 1425.

According to an embodiment, the third region 1263 of the printed circuit board 1260 may include a second ground 1272. The second ground 1272 may be electrically connected to the second conductive member 1312. For example, the second ground 1272 may be electrically connected to the second conductive member 1312 via a third conductive connection member 1423. For example, the second ground 1272 may be electrically connected to the second conductive member 1312 via a fourth conductive connection member 1424.

According to an embodiment, as the first conductive member 1311 and the second conductive member 1312 are electrically connected to the grounds at various points, the wireless communication circuit 1270 may transmit and/or receive RF signals of multiple frequency bands. In addition, as the first conductive member 1311 is electrically connected to the first ground 1271 at various points, even when one conductive connection member (e.g., the second conductive connection member 1422) fails, the first conductive member 1311 may maintain a connection with the first ground 1271. As another example, as the second conductive member 1312 is electrically connected to the second ground 1272 at various points, even when one conductive connection member (e.g., the third conductive connection member 1423) fails, the second conductive member 1312 may maintain a connection with the second ground 1272.

In the disclosure, the first ground 1271 has been described as being electrically connected to the first conductive member 1311 at a plurality of points, but this is merely an example. For example, the first ground 1271 may be electrically connected to the first conductive member 1311 at a single point.

In the disclosure, the term "conductive region" may be replaced with the term "conductive layer," "conductive connection portion," "connecting portion," "ground region," or "ground fill region."

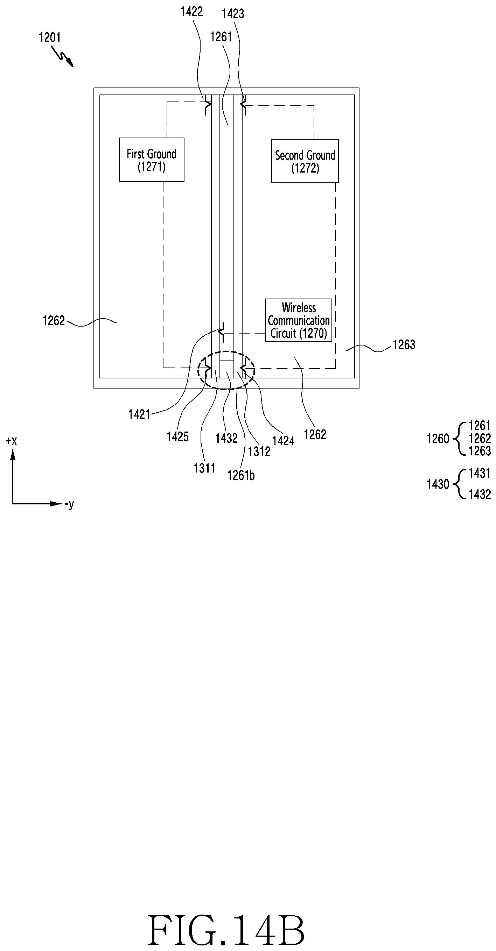

FIG. 14B is a view illustrating a second conductive region formed in the first region between the first conductive member and the second conductive member according to an embodiment.

Referring to FIG. 14B, a second conductive region 1432 may be formed at the second end 1261b of the first region 1261 according to an embodiment. For example, the second conductive region 1432 may be referred to as a portion of a region including a conductive layer of the printed circuit board 1260.

The embodiment of FIG. 14B of the disclosure may be referred to as an embodiment in which the first conductive region 1431 of the embodiment of FIG. 14A is omitted.

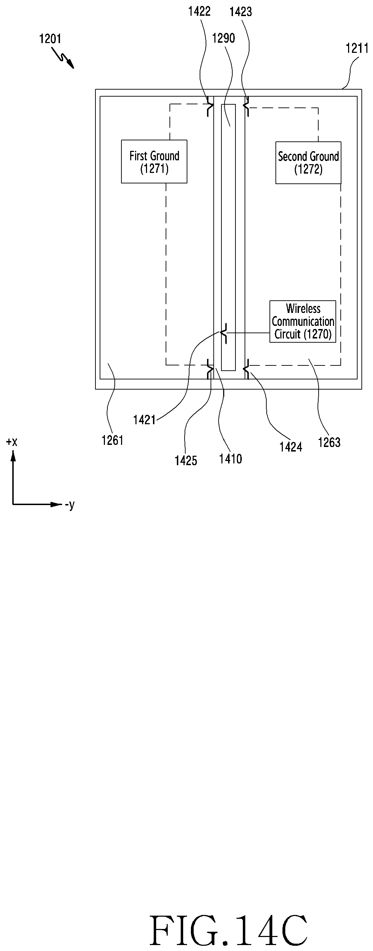

FIG. 14C is a view illustrating a conductive member including a first conductive portion and a second conductive portion according to an embodiment.

Referring to FIG. 14C, an electronic device 1201 according to an embodiment may include a conductive member 1410 disposed at a center of the first housing 1211.

The conductive member 810 of FIG. 8A of the disclosure may correspond to a case in which the first conductive member 1311 and the second conductive member 1312 of FIG. 13 are integrally formed.

According to an embodiment, a slot 1290 may be formed in the conductive member 1310. For example, the slot 1290 may be a cavity formed in the conductive member 1410. For example, a non-conductive material or a dielectric material (e.g., air or an injection-molded material) may be disposed in the slot 1290.

According to an embodiment, a wireless communication circuit 1270 may feed power to the conductive member 1410 through a first conductive connection member 1421. Due to the feeding by the wireless communication circuit 1270, an electrical path may be formed in the conductive member 1410 along an edge of the slot 1290. The wireless communication circuit 1270 may transmit and/or receive RF signals of a predetermined frequency band based on the electrical path formed in the conductive member 1410.

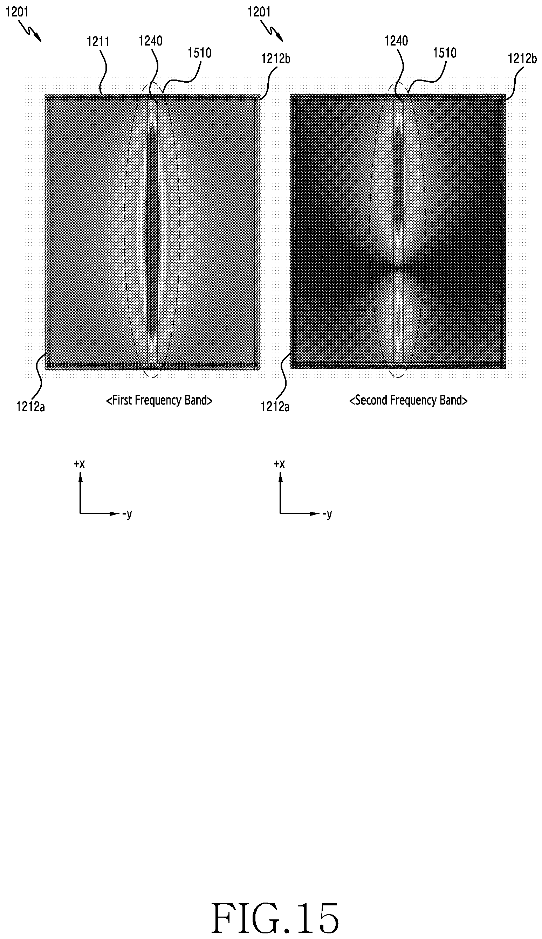

FIG. 15 is a view illustrating current distributions according to frequency bands transmitted by the wireless communication circuit according to an embodiment.

Referring to FIG. 15, a current distribution formed in the electronic device 1201 when the wireless communication circuit 1270 according to an embodiment transmits RF signals of a first frequency band (e.g., a frequency band including about 1.57 GHz) to the first conductive member 1311 is illustrated. In addition, a current distribution formed in the electronic device 1201 when the wireless communication circuit 1270 transmits RF signals of a second frequency band (e.g., a frequency band including about 2.4 GHz) to the first conductive member 1311 is illustrated. For example, the second frequency band may correspond to a harmonic resonance frequency band of the first frequency band.

In the disclosure, the first conductive member 1311 and the second conductive member 1312 in the electronic device 101 are not illustrated, but a first region 1510 may be understood as a region substantially including the first conductive member 1311 and the second conductive member 1312.

From the fact that current distributions are formed in the first region 1510, it is identified that radiation performance equal to or greater than a predetermined value is secured in both cases where the electronic device 1201 transmits RF signals of the first frequency band to the first conductive member 1311 or transmits RF signals of the second frequency band to the first conductive member 1311.

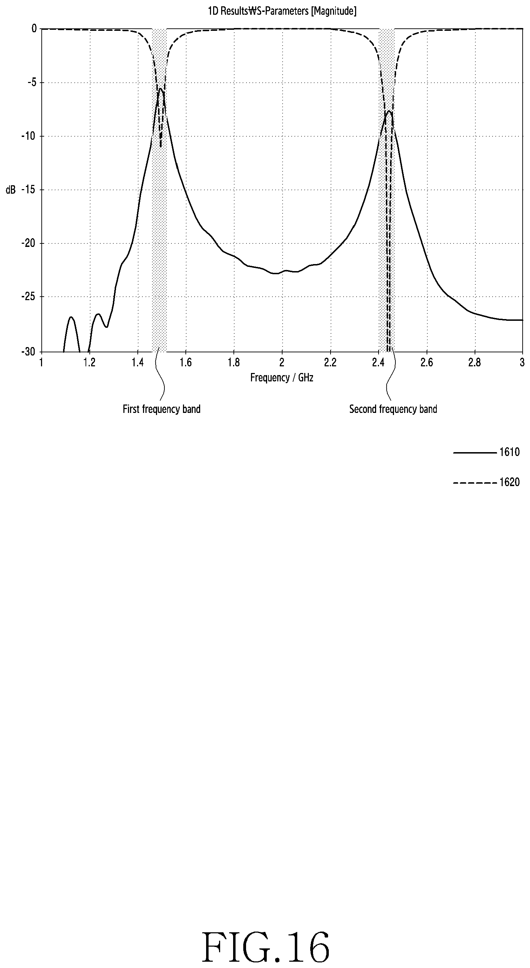

FIG. 16 illustrates a radiation efficiency graph and a reflection coefficient graph of an antenna including the first conductive member and the second conductive member when the wireless communication circuit feeds power to the first conductive member according to an embodiment.

Referring to FIG. 16, a first graph 1610 according to an embodiment is a radiation efficiency graph of an antenna including the first conductive member 1311 and the second conductive member 1312 when the wireless communication circuit 1270 feeds power to the first conductive member 1311. A second graph 1620 is a reflection coefficient graph of signals radiated by the antenna including the first conductive member 1311 and the second conductive member 1312 when the wireless communication circuit 1270 feeds power to the first conductive member 1311.

Referring to the first graph 1610 and the second graph 1620, it is confirmed that radiation efficiency values of about 10 dB or more are shown in a first frequency band (e.g., a frequency band including about 1.5 GHz) and a second frequency band (e.g., a frequency band including about 2.4 GHz). In addition, it is confirmed that reflection coefficient values of about 5 dB or less are shown in the first frequency band and the second frequency band.

Accordingly, it is confirmed that the electronic device 101 may secure antenna performance equal to or greater than a predetermined value in the first frequency band and the second frequency band through an antenna including the first conductive member 1311 and the second conductive member 1312.

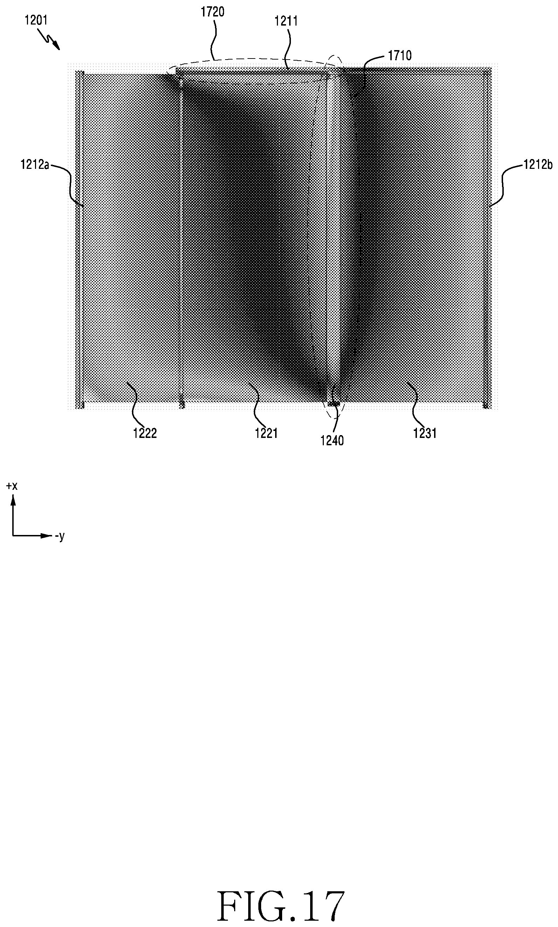

FIG. 17 illustrates a current distribution when the first part of the second housing moves in a direction away from the first housing and the wireless communication circuit feeds power to the first conductive member according to an embodiment.

Referring to FIG. 17, when the first part 1212a according to an embodiment moves in the second direction (e.g., the +y direction) due to a user input or a physical force of a user, a current distribution formed when the wireless communication circuit 1270 feeds power to the first conductive member 1311 is illustrated.

According to an embodiment, since the second part 1212b is not slid out from the first housing 1211, current may be relatively reduced in a first portion 1710 corresponding to the non-conductive material 1240, but it is confirmed that relatively high current is still distributed in a second portion 1720.

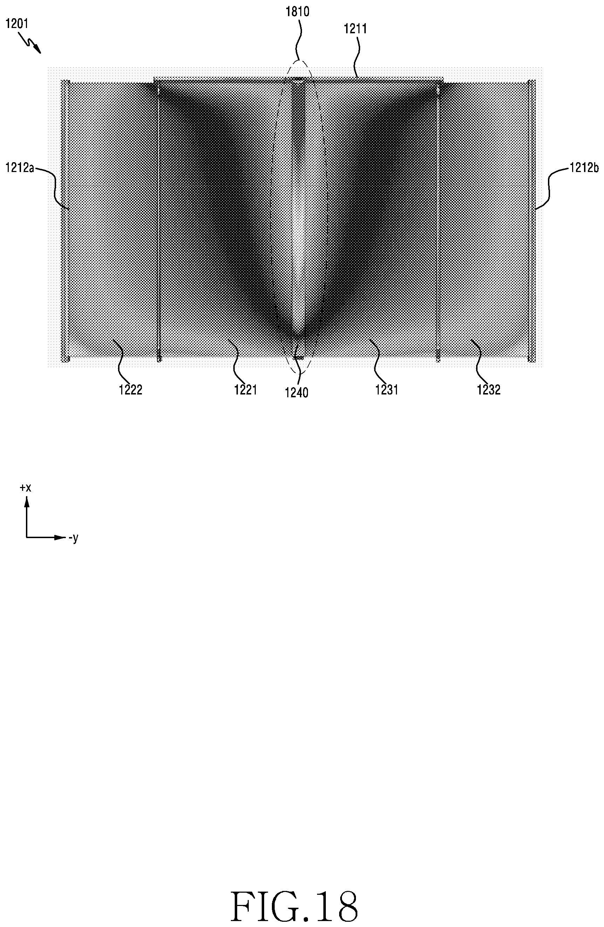

FIG. 18 illustrates a current distribution when the first part and the second part of the second housing move in a direction away from the first housing and the wireless communication circuit feeds power to the first conductive member according to an embodiment.

Referring to FIG. 18, when the first part 1212a according to an embodiment moves in the second direction (e.g., the +y direction) due to a user input or a physical force of a user and the second part 1212b moves in the first direction (e.g., the -y direction), a current distribution formed when the wireless communication circuit 1270 feeds power to the first conductive member 1311 is illustrated.

It is confirmed that a current distribution is formed in a first portion 1810 corresponding to the non-conductive material 1240. Accordingly, the electronic device 1201 may secure antenna radiation performance equal to or greater than a predetermined value when the first part 1212a and the second part 1212b move away from the first housing 1211.

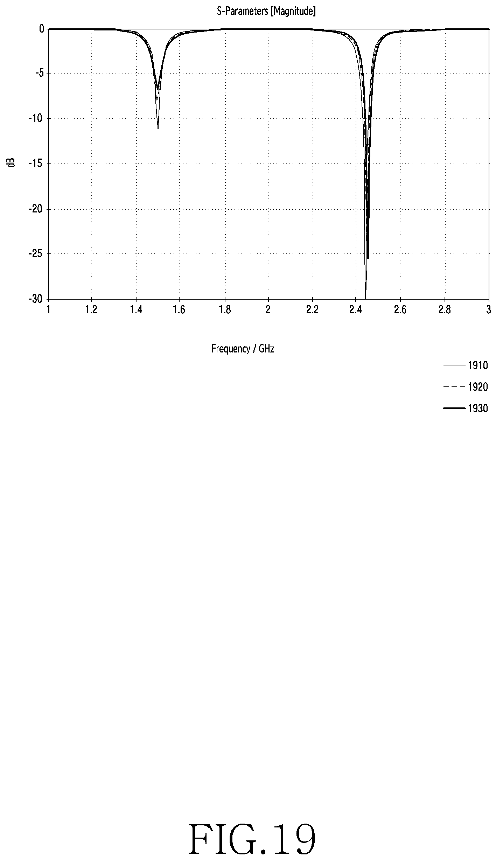

FIG. 19 illustrates reflection coefficient graphs corresponding to cases in which the first part or the second part of the second housing according to an embodiment is slid out and in which the first part or the second part is not slid out.

Referring to FIG. 19, a first graph 1910 according to an embodiment is a reflection coefficient graph of signals radiated by an antenna including the first conductive member 1311 and the second conductive member 1312 when the first part 1212a and the second part 1212b of the second housing 1212 do not move and are in contact with the first housing 1211. A second graph 1920 is a reflection coefficient graph of signals radiated by an antenna including the first conductive member 1311 and the second conductive member 1312 when the first part 1212a of the second housing 1212 moves in the second direction (e.g., the +y direction). A third graph 1930 is a reflection coefficient graph of signals radiated by an antenna including the first conductive member 1311 and the second conductive member 1312 when the first part 1212a moves in the second direction (e.g., the +y direction) and the second part 1212b moves in the first direction (e.g., the -y direction).

Referring to the first graph 1910, the second graph 1920, and the third graph 1930, it is confirmed that reflection coefficient values of about -5 dB or less are shown in a first frequency band (e.g., a frequency band including about 1.57 GHz). Accordingly, it is confirmed that the electronic device 1301 may secure radiation performance equal to or greater than a predetermined value in both cases where the first part 1212a and the second part 1212b move in a direction away from the first housing 1211 and where the first part 1212a and the second part 1212b do not move.

Referring to the first graph 1910, the second graph 1920, and the third graph 1930, it is confirmed that reflection coefficient values of about -20 dB or less are shown in a second frequency band (e.g., a frequency band including about 2.4 GHz). Accordingly, it is confirmed that the electronic device 1301 may secure radiation performance equal to or greater than a predetermined value in both cases where the first part 1212a and the second part 1212b move in a direction away from the first housing 1211 and where the first part 1212a and the second part 1212b do not move.

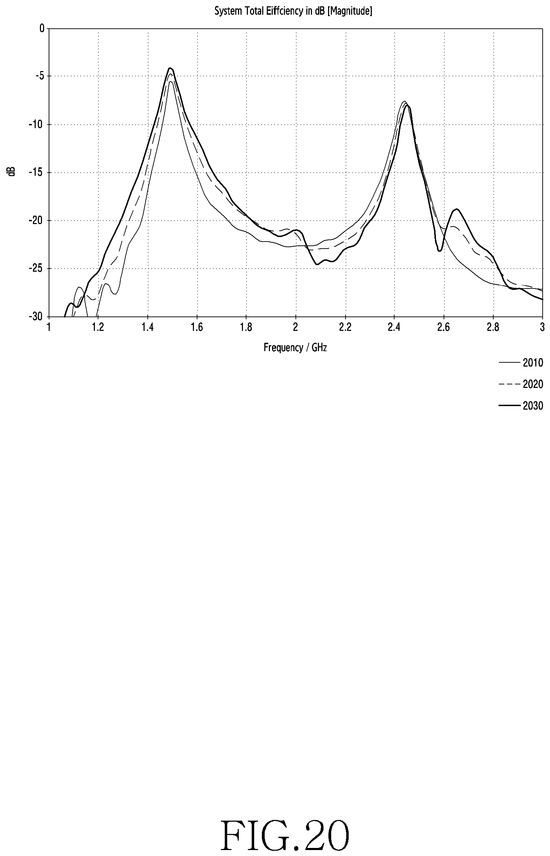

FIG. 20 illustrates antenna radiation efficiency graphs corresponding to cases in which the first part or the second part of the second housing according to an embodiment is slid out and in which the first part or the second part is not slid out.

Referring to FIG. 20, a first graph 2010 according to an embodiment is a radiation efficiency graph of an antenna including the first conductive member 1311 and the second conductive member 1312 when the first part 1212a and the second part 1212b of the second housing 1212 do not move and are in contact with the first housing 1211. A second graph 2020 is a radiation efficiency graph of an antenna including the first conductive member 1311 and the second conductive member 1312 when the first part 1212a of the second housing 1212 moves in the second direction (e.g., the +y direction). A third graph 2030 is a radiation efficiency graph of an antenna including the first conductive member 1311 and the second conductive member 1312 when the first part 1212a moves in the second direction (e.g., the +y direction) and the second part 1212b moves in the first direction (e.g., the -y direction).

Referring to the first graph 2010, the second graph 2020, and the third graph 2030, it is confirmed that radiation efficiency values of about -5 dB or greater are shown in a first frequency band (e.g., a frequency band including about 1.57 GHz). Accordingly, it is confirmed that the electronic device 1301 may secure radiation performance equal to or greater than a predetermined value in both cases where the first part 1212a and the second part 1212b move in a direction away from the first housing 1211 and where the first part 1212a and the second part 1212b do not move.

Referring to the first graph 2010, the second graph 2020, and the third graph 2030, it is confirmed that radiation efficiency values of about -10 dB or greater are shown in a second frequency band (e.g., a frequency band including about 2.4 GHz). Accordingly, it is confirmed that the electronic device 1301 may secure antenna radiation performance equal to or greater than a predetermined value when the first part 1212a and the second part 1212b move away from the first housing 1211.

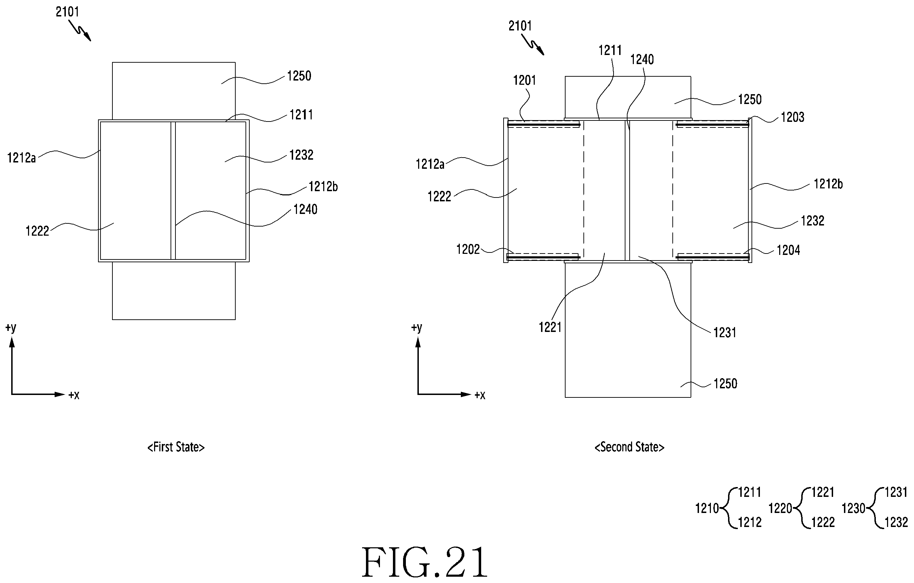

FIG. 21 illustrates a first state and a second state of an electronic device according to an embodiment.

Referring to FIG. 21, an electronic device 2101 (e.g., a wearable device) according to an embodiment may include a housing 1210, a display 1220, a non-conductive material 1240, and/or a fastening member 1250.

Unlike the electronic device 1201 of FIG. 12, the housing 1210 of FIG. 21 of the disclosure illustrates an embodiment in which the second housing 1212 is coupled to the fastening member 1250 so as to be movable in a direction perpendicular to the fastening member 1250. For example, the second housing 1212 of FIG. 21 may move in a direction (e.g., the x-axis direction) perpendicular to a direction in which the fastening member 1250 is arranged (e.g., the y-axis direction). On the other hand, the second housing 1212 of FIG. 12 may move in a direction parallel to the direction in which the fastening member 1250 is arranged (e.g., the y-axis direction).

As another example, the embodiment of FIG. 21 may substantially correspond to a case in which the housing 1210 of the embodiment of FIG. 12 is rotated by about -90 degrees.

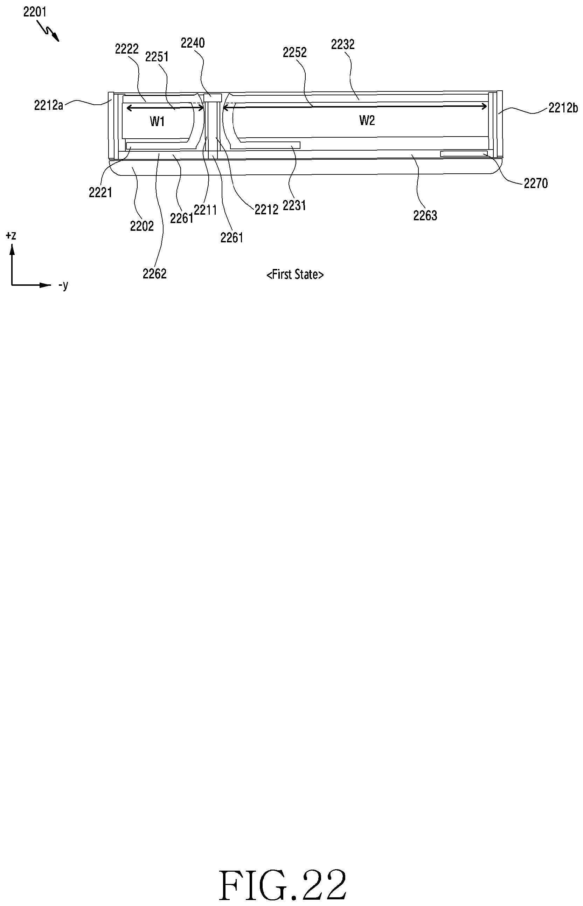

FIG. 22 illustrates an electronic device including displays having different widths according to an embodiment.

Referring to FIG. 22, the electronic device 2201 according to an embodiment may include a first conductive member 2211, a second conductive member 2212, a printed circuit board 2260, a wireless communication circuit 2270, a first battery 2251, and/or a second battery 2252.

In the embodiment of FIG. 22 of the disclosure, unlike the embodiment of FIG. 12, widths of a first display 2220 and a second display 2230 may be different from each other.

For example, in the embodiment of FIG. 12, a portion of the first display 1220 exposed to the exterior of the electronic device 1201 and a portion of the second display 1230 exposed to the exterior of the electronic device 1201 may have substantially the same width and may be symmetrical with each other. In the embodiment of FIG. 22, a portion of the first display 2220 exposed to the exterior of the electronic device 2201 may have a first width W1, and a portion of the second display 2230 exposed to the exterior may have a second width W2. That is, in the embodiment of FIG. 22, portions of respective displays exposed to the exterior of the electronic device 2201 may differ from each other.

For example, in the embodiment of FIG. 12, the entirety of the first display 1220 and the entirety of the second display 1230 may have substantially the same width and may be symmetrical with each other. In the embodiment of FIG. 22, the first display 2220 may entirely have a third width, and the second display 2230 may entirely have a fourth width greater than the third width.

In addition, in the embodiment of FIG. 22 of the disclosure, unlike the embodiment of FIG. 12, sizes of the first battery 2251 and the second battery 2252 may differ from each other. For example, in the embodiment of FIG. 12, the first battery 1251 and the second battery 1252 may have substantially the same size and may be symmetrical with each other. In the embodiment of FIG. 22, the first battery 2251 may have a size smaller than that of the second battery 2252.

In addition, in the embodiment of FIG. 22 of the disclosure, unlike the embodiment of FIG. 12, the first region 2261 of the printed circuit board 2260 may be formed closer to the first part 2212a than to the second part 2212b. For example, in the embodiment of FIG. 12, the first region 1261 may be spaced apart from the first part 1212a and the second part 1212b by substantially the same distance. In contrast, in the embodiment of FIG. 22, the first region 1261 may be disposed closer to the first part 2212a than to the second part 2212b.

As another example, the first region 1261 may be located in the first direction (e.g., the -y direction) with respect to a center of the first housing.

In addition, in the embodiment of FIG. 22 of the disclosure, unlike the embodiment of FIG. 12, the non-conductive member 2240 may be disposed closer to the first part 2212a than to the second part 2212b. For example, in the embodiment of FIG. 12, the non-conductive member 2240 may be spaced apart from the first part 1212a and the second part 1212b by substantially the same distance. In contrast, in the embodiment of FIG. 22, the non-conductive member 2240 may be disposed closer to the first part 1212a than to the second part 1212b.

According to an embodiment, the first housing may include a rear surface cover 2202. For example, the rear surface cover 2202 may form a rear surface of the electronic device 2201 and may come into contact with a user's body (e.g., a wrist) when the electronic device 2201 is mounted on the user's body (e.g., the wrist). A fastening member 1250 (e.g., a strap) may be coupled to the rear surface cover 2202.

According to an embodiment, the printed circuit board 2260 may include a first region 2261, a second region 2262, and/or a third region 2263. For example, the first region 2261 may include a non-conductive material, and the second region 2262 and the third region 2263 may include a conductive material. For example, the first region 2261 may be located between the second region 2262 and the third region 2263.

According to an embodiment, the first conductive member 2211 and/or the second conductive member 2212 may be disposed within the first housing. For example, the first conductive member 311 may be disposed between the first display 2220 and the second display 2230.

The first housing of FIG. 22 of the disclosure may correspond to the first housing 1211 of FIG. 12, the second housing may correspond to the second housing 1212 of FIG. 12, and the wireless communication circuit 2270 of FIG. 22 may correspond to the wireless communication circuit 323 of FIG. 3.

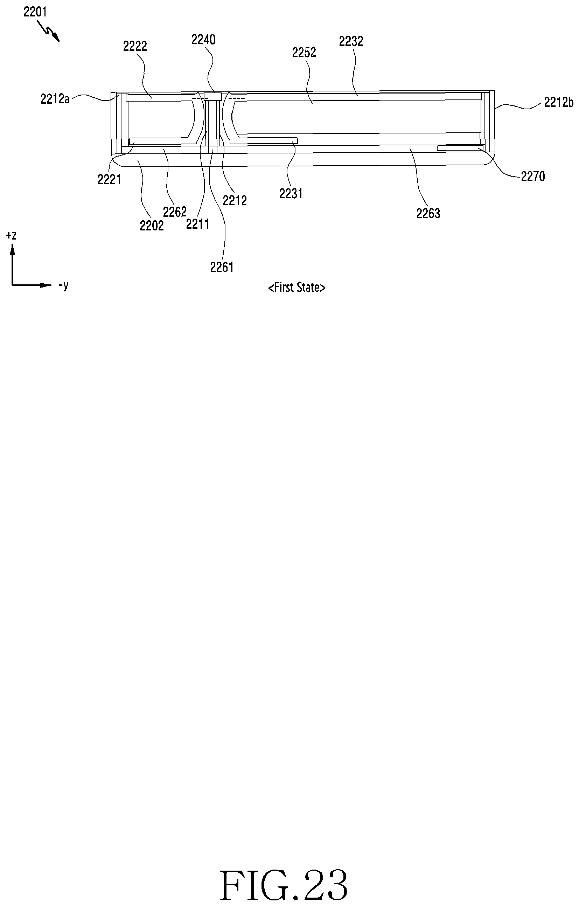

FIG. 23 illustrates an electronic device including a second battery.

Referring to FIG. 23, an electronic device 2201 according to an embodiment may include only one battery within the electronic device 2201. For example, the electronic device 2201 may not include the first battery 2251 of FIG. 22 and may include only the second battery 2252.

With reference to FIG. 23 of the disclosure, the electronic device 2201 has been described as including only the second battery 2252, but this is merely an example. For example, the electronic device 2201 may include only the first battery 2251 and may not include the second battery 2252.

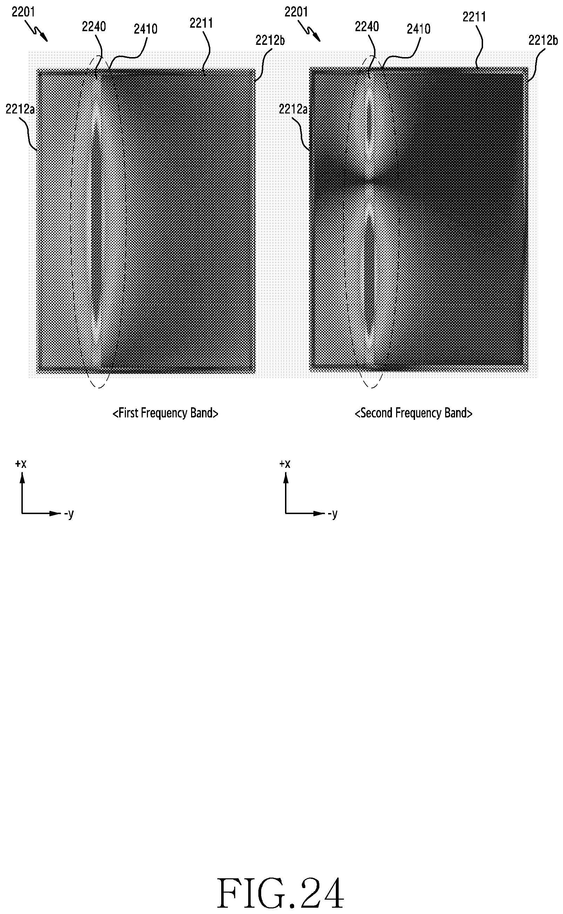

FIG. 24 is a view illustrating current distributions according to frequency bands transmitted by the wireless communication circuit according to an embodiment.

Referring to FIG. 24, a current distribution formed in the electronic device 2201when the wireless communication circuit 2270 according to an embodiment feeds power to the first conductive member 2211 to transmit RF signals of a first frequency band (e.g., about 1.57 GHz) is illustrated. In addition, a current distribution formed in the electronic device 2201 when the wireless communication circuit 2270 feeds power to the first conductive member 2211 to transmit RF signals of a second frequency band (e.g., a frequency band including about 2.4 GHz) is illustrated.

In the disclosure, the first conductive member 2211 and the second conductive member 2212 in the electronic device 2201 are not illustrated, but a first region 2410 may be understood as a region substantially including the first conductive member 2211 and the second conductive member 2212.

From the fact that current distributions are formed in the first region 2410, it is identified that radiation performance equal to or greater than a predetermined value is secured in both cases where the electronic device 2201 transmits RF signals of the first frequency band to the first conductive member 2211 or transmits RF signals of the second frequency band to the first conductive member 2211.

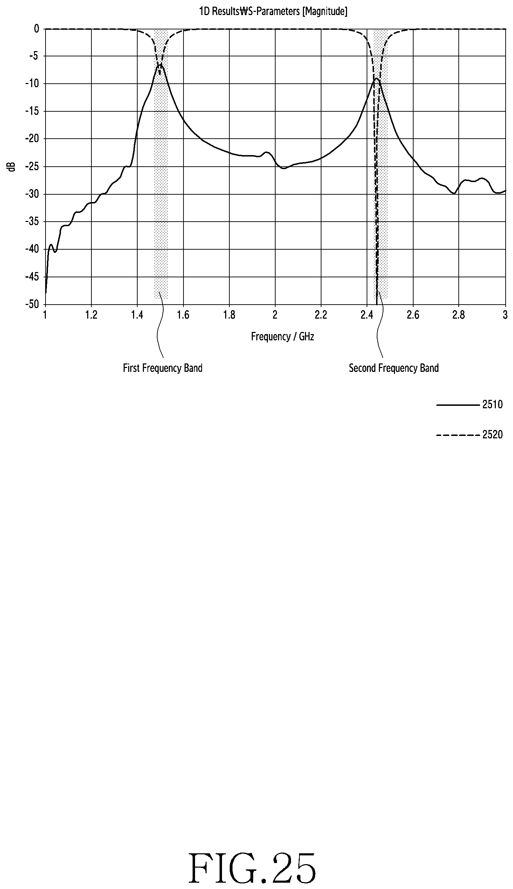

FIG. 25 illustrates a radiation efficiency graph and a reflection coefficient graph of an antenna including the first conductive member and the second conductive member when the wireless communication circuit feeds power to the first conductive member according to an embodiment.

Referring to FIG. 25, a first graph 2510 according to an embodiment is a radiation efficiency graph of an antenna including the first conductive member 2211 and the second conductive member 2212 when the wireless communication circuit 2270 feeds power to the first conductive member 2211. A second graph 2520 is a reflection coefficient graph of signals radiated by the antenna including the first conductive member 2211 and the second conductive member 2212 when the wireless communication circuit 2270 feeds power to the first conductive member 2211.

Referring to the first graph 2510 and the second graph 2520, it is confirmed that radiation efficiency values of about -10 dB or more are shown in a first frequency band (e.g., a frequency band including about 1.5 GHz) and a second frequency band (e.g., a frequency band including about 2.4 GHz). In addition, it is confirmed that reflection coefficient values of about -5 dB or less are shown in the first frequency band and the second frequency band.

Accordingly, it is confirmed that the electronic device 2201 may secure antenna performance equal to or greater than a predetermined value in the first frequency band and the second frequency band through an antenna including the first conductive member 2211 and the second conductive member 2212.

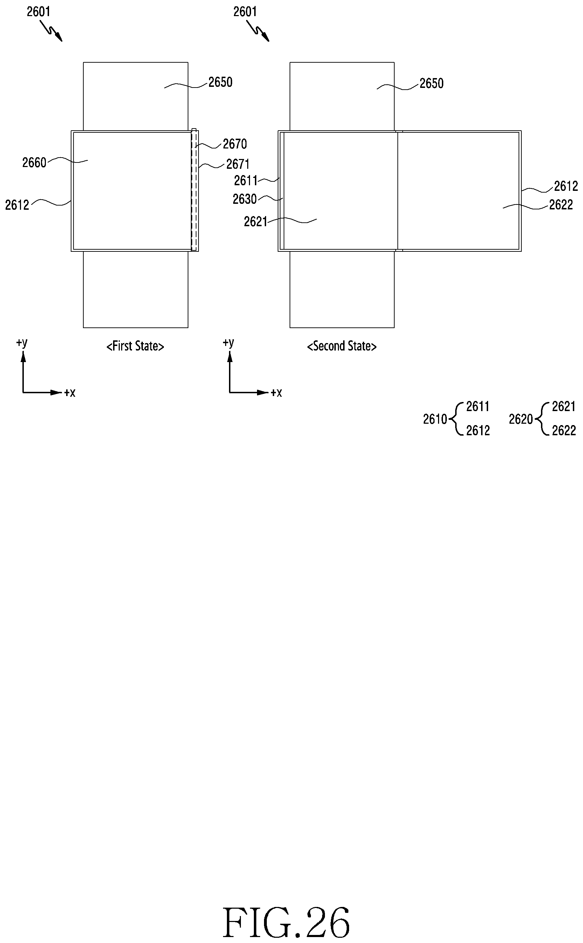

FIG. 26 illustrates an electronic device including a foldable display according to an embodiment.

Referring to FIG. 26, an electronic device 2601 according to an embodiment may include a housing 2610, a display 2620, a sub-display 2660, a hinge 2630, a hinge cover 2631, and/or a fastening member 2650.

According to an embodiment, the housing 2610 may include a first housing 2611 and a second housing 2612 connected to the first housing 2611 so as to be foldable with respect thereto. For example, the first housing 2611 and the second housing 2612 may be coupled to each other via the hinge 2630, and the second housing 2612 may be folded or unfolded with respect to the first housing 2611 via the hinge 2630.

According to an embodiment, the hinge cover 2631 may cover the hinge 2630. For example, the hinge cover 2631 may prevent foreign substances from being introduced into the hinge 2630 from the exterior of the electronic device 2601 when the hinge 2630 is folded or unfolded.

According to an embodiment, the display 2620 may include a first display portion 2621 and a second display portion 2622. The display 2620 may be folded about a folding axis (e.g., the y-axis), and the first display portion 2621 may face or be aligned with the second display portion 2622.

According to an embodiment, in a second state, the display 2620 may be disposed to be oriented in a fourth direction (e.g., the +z direction), and in a first state, as the second display portion 2622 of the display 2620 is folded, the sub-display 2660 located on a rear surface of the second display portion 2622 may be disposed to be oriented in the fourth direction (e.g., the +z direction).

According to an embodiment, the electronic device 2601 may have the first state and the second state. For example, the first state may be referred to as a state in which the display 2620 is folded about the folding axis (e.g., the y-axis). In this case, the first display portion 2621 and the second display portion 2622 may face each other. For example, the second state may be referred to as a state in which the display 2620 is unfolded. In this case, the first display portion 2621 and the second display portion 2622 may be oriented in the fourth direction (e.g., the +z direction).

For example, the first state may be referred to as a state in which the first display portion 2621 and the second display portion 2622 form an angle of about 0 degrees therebetween. The second state may be referred to as a state in which the first display portion 2621 and the second display portion 2622 form an angle of about 180 degrees therebetween. In this case, the sub-display 2660 may be oriented in the fourth direction (e.g., the +z direction).

The fastening member 2650 of FIG. 26 of the disclosure may correspond to the fastening member 250 of FIG. 2, and the description of the fastening member 250 of FIG. 2 may be applied to the fastening member 2650.

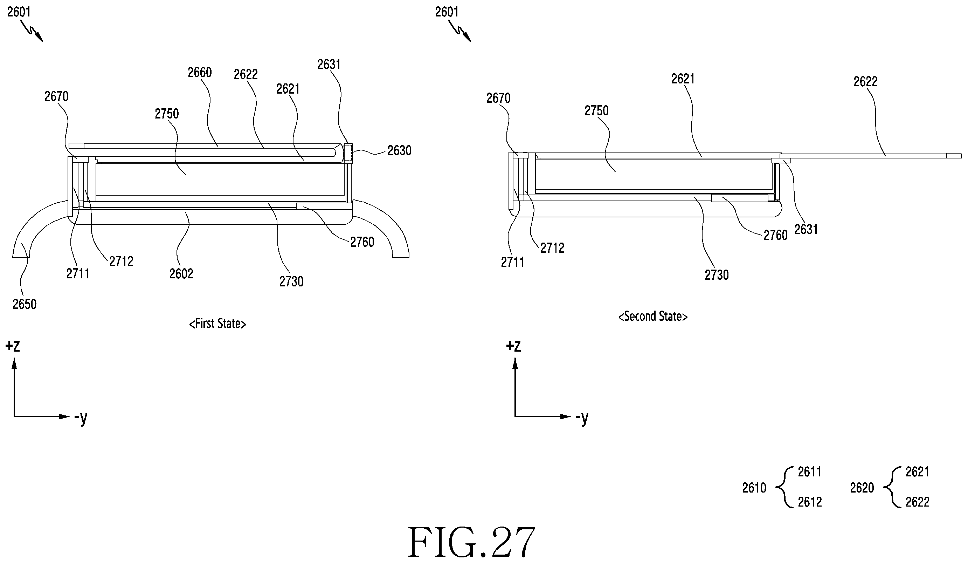

FIG. 27 illustrates an electronic device including a foldable display according to an embodiment.

Referring to FIG. 27, an electronic device 101 according to an embodiment may include a first conductive member 2711, a second conductive member 2712, a printed circuit board 2730, a rear surface cover 2602, and/or a battery 2750.

The first conductive member 2711, the second conductive member 2712, the printed circuit board 2730, the rear surface cover 2602, and the battery 330 of FIG. 27 of the disclosure may respectively correspond to the first conductive member 311, the second conductive member 312, the printed circuit board 320, the rear surface cover 302, and the battery 2750 of FIG. 3. Accordingly, descriptions of the first conductive member 311, the second conductive member 312, the printed circuit board 320, the rear surface cover 302, and the battery 2750 of FIG. 3 may be applied to the first conductive member 2711, the second conductive member 2712, the printed circuit board 2730, the rear surface cover 2602, and the battery 330, respectively.

According to an embodiment, in the first state, the first display portion 2621 and the second display portion 2622 may face each other, and in the second state, the first display portion 2621 and the second display portion 2622 may be oriented in a fourth direction (e.g., the +z direction).

According to an embodiment, in the first state and the second state, the wireless communication circuit 2760 may feed power to at least one of the first conductive member 2711 or the second conductive member 2712. The wireless communication circuit 2760 may transmit and/or receive RF signals of a predetermined frequency band based on electrical paths formed in the first conductive member 2711 and the second conductive member 2712.

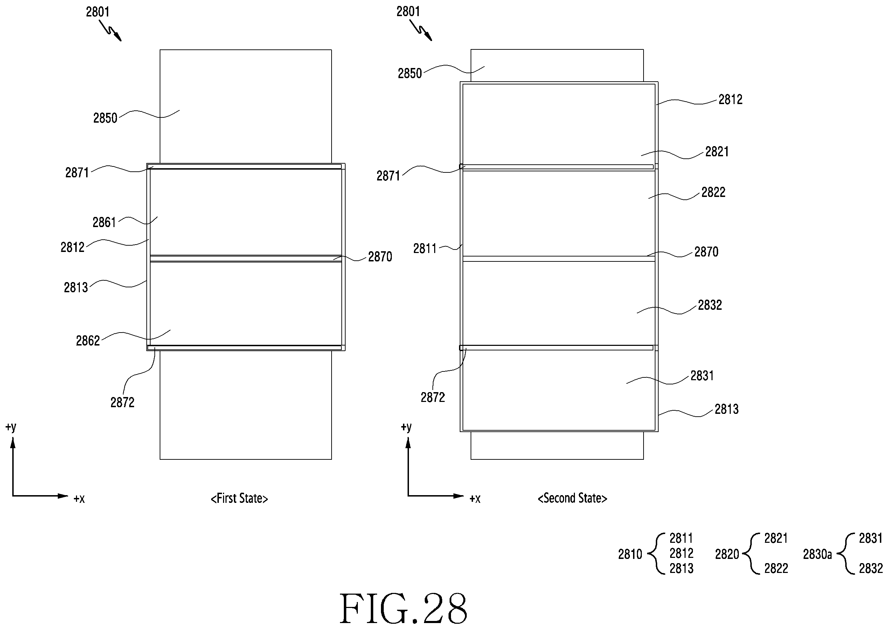

FIG. 28 illustrates an electronic device including a foldable display according to an embodiment.

Referring to FIG. 28, an electronic device 2801 according to an embodiment may include a housing 2810, a first display 2820, a second display 2830a, a first sub-display 2861, a second sub-display 2862, a first hinge 2871, a second hinge 2872, a non-conductive member 2830, and/or a fastening member 2850.

According to an embodiment, the housing 2810 may include a first housing 2811, a second housing 2812 connected to the first housing 2811 so as to be foldable with respect thereto, and/or a third housing 2813 connected to the first housing 2811 so as to be foldable with respect thereto. For example, the first housing 2811 and the second housing 2812 may be coupled to each other via the first hinge 2871, and the second housing 2812 may be folded or unfolded with respect to the first housing 2811 via the first hinge 2871. For example, the first housing 2811 and the third housing 2813 may be coupled to each other via the second hinge 2872, and the third housing 2813 may be folded or unfolded with respect to the first housing 2811 via the second hinge 2872.

According to an embodiment, the first display 2820 may include a first display portion 2821 and a second display portion 2822. For example, the first display 2820 may be folded or unfolded about a folding axis (e.g., the x-axis). For example, when the first display 2820 is folded about the folding axis (e.g., the x-axis), the first display portion 2821 and the second display portion 2822 may face each other. When the first display 2820 is unfolded, the first display portion 2821 and the second display portion 2822 may be oriented in a fourth direction (e.g., the +z direction).

According to an embodiment, the second display 2830a may include a third display portion 2831 and a fourth display portion 2832. For example, the second display 2830a may be folded or unfolded about a folding axis (e.g., the x-axis). For example, when the second display 2830a is folded about the folding axis (e.g., the x-axis), the third display portion 2831 and the fourth display portion 2832 may face each other. When the second display 2830a is unfolded, the third display portion 2831 and the fourth display portion 2832 may be oriented in the fourth direction (e.g., the +z direction).

According to an embodiment, in the second state, the first display 2820 and the second display 2830a may be disposed to be oriented in the fourth direction (e.g., the +z direction), and in the first state, as the first display portion 2821 of the first display 2820 is folded, the first sub-display 2861 positioned on the rear surface of the first display portion 2821 may be disposed to be oriented in the fourth direction (e.g., the +z direction). In the first state, as the third display portion 2831 of the second display 2830a is folded, the second sub-display 2862 located on the rear surface of the third display portion 2831 may be disposed to be oriented in the fourth direction (e.g., the +z direction).

According to an embodiment, the first display 2820 may be disposed on the first housing 2811 and the second housing 2812. For example, the second display portion 2822 may be disposed on the first housing 2811, and the first display portion 2821 may be disposed on the second housing 2812.

According to an embodiment, the second display 2830a may be disposed on the first housing 2811 and the third housing 2813. For example, the fourth display portion 2832 may be disposed on the first housing 2811, and the third display portion 2831 may be disposed on the third housing 2813.

According to an embodiment, the electronic device 2801 may have the first state and the second state. For example, the first state may be referred to as a state in which the first display 2820 and the second display 2830a are folded about a folding axis (e.g., the x-axis). In this case, the first display portion 2821 and the second display portion 2822 may face each other, and the third display portion 2831 and the fourth display portion 2832 may face each other. For example, the second state may be referred to as a state in which the display 2620 is unfolded. In this case, the first display portion 2821 and the second display portion 2822 may be oriented in the fourth direction (e.g., the +z direction), and the third display portion 2831 and the fourth display portion 2832 may be oriented in the fourth direction (e.g., the +z direction).

For example, the first state may be referred to as a state in which the first display portion 2821 and the second display portion 2822 form an angle of about 0 degrees therebetween. The second state may be referred to as a state in which the first display portion 2821 and the second display portion 2822 form an angle of about 180 degrees therebetween. The first state may be referred to as a state in which the third display portion 2831 and the fourth display portion 2832 form an angle of about 0 degrees therebetween. The second state may be referred to as a state in which the third display portion 2831 and the fourth display portion 2832 form an angle of about 180 degrees therebetween.

According to an embodiment, the electronic device 2801 may include a non-conductive portion 2870, and the non-conductive portion 2870 may be disposed on the front surface of the electronic device 2801. The non-conductive portion 2870 may be disposed between the first display 2820 and the second display 2830a.

The non-conductive member 2830 of the disclosure may correspond to the non-conductive material 1240 of FIG. 12, and the description of the non-conductive material 1240 of FIG. 12 may be applied to the non-conductive member 2830 unless inconsistent.

The fastening member 2850 of FIG. 28 of the disclosure may correspond to the fastening member 250 of FIG. 2, and the description of the fastening member 250 of FIG. 2 may be applied to the fastening member 2850.

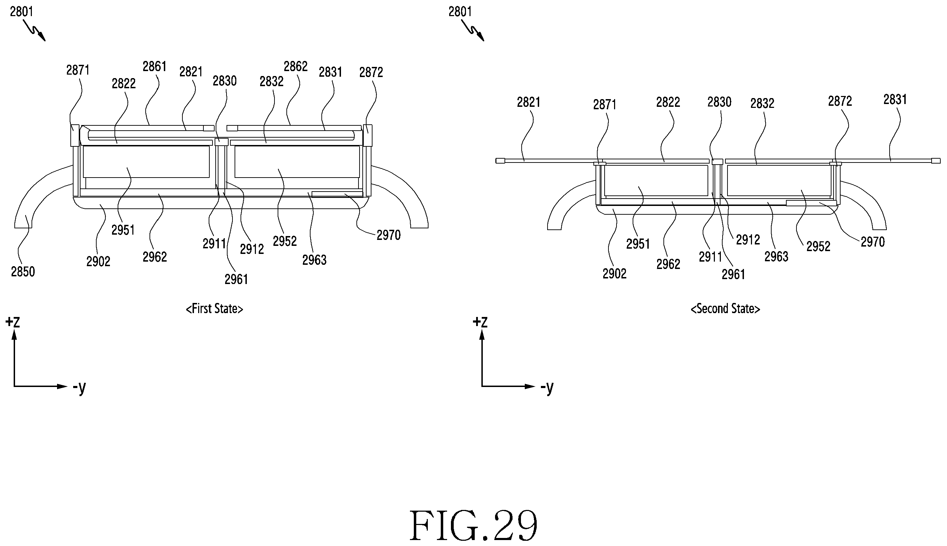

FIG. 29 illustrates an electronic device including a foldable display according to an embodiment.

Referring to FIG. 29, an electronic device 2801 according to an embodiment may include a first conductive member 2911, a second conductive member 2912, a first battery 2951, a second battery 2952, a printed circuit board 2960, a rear surface cover 2902, a wireless communication circuit 2970, and/or a fastening member 2850.

The first conductive member 2911, the second conductive member 2912, the first battery 2951, the second battery 2952, the printed circuit board 2960, the rear surface cover 2902, the wireless communication circuit 2970, and the fastening member 2850 of FIG. 29 of the disclosure may respectively correspond to the first conductive member 1311, the second conductive member 1312, the first battery 1251, the second battery 1252, the printed circuit board 1260, the rear surface cover 1202, the wireless communication circuit 1270, and the fastening member 1250 of FIG. 13.

According to an embodiment, the first region 2961, the second region 2962, and the third region 2963 of the printed circuit board 2960 may correspond to the first region 1261, the second region 1262, and the third region 1263 of FIG. 13.

According to an embodiment, in the first state, the first display portion 2821 and the second display portion 2822 may face each other, and the third display portion 2823 and the fourth display portion 2824 may face each other. In the second state, the first display portion 2821 and the second display portion 2822 may be oriented in the fourth direction (e.g., the +z direction), and the third display portion 2831 and the fourth display portion 2832 may be oriented in the fourth direction (e.g., the +z direction).

According to an embodiment, in the first state and the second state, the wireless communication circuit 2970 may feed power to at least one of the first conductive member 2911 or the second conductive member 2912. The wireless communication circuit 2970 may transmit and/or receive RF signals of a predetermined frequency band based on electrical paths formed in the first conductive member 2911 and the second conductive member 2912.

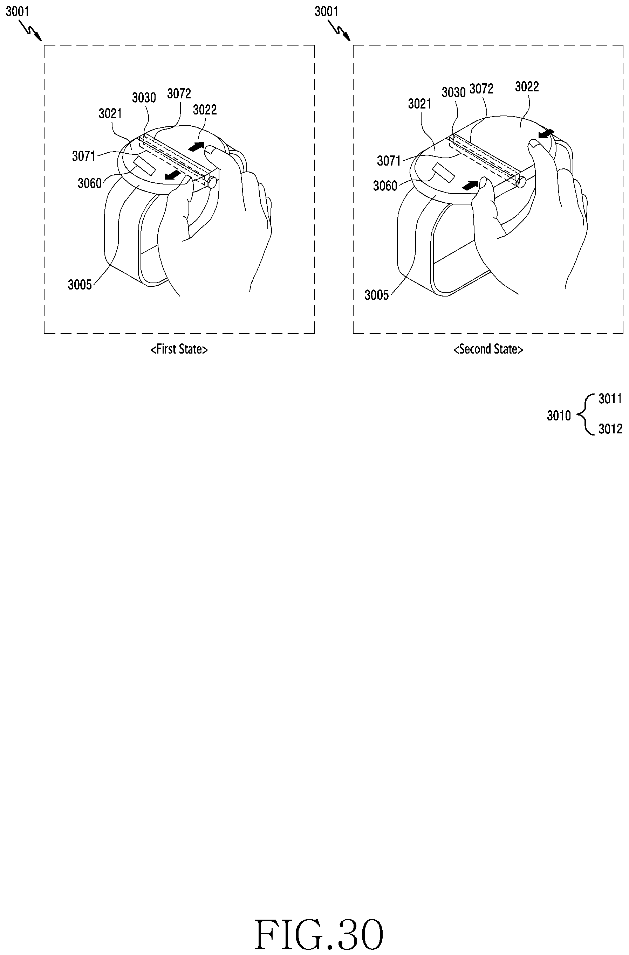

FIG. 30 illustrates an electronic device having a circular shape according to an embodiment.

Referring to FIG. 30, when the electronic device 3001 according to an embodiment is in a first state, a display 3010 including a first display 3011 and a second display 3012 may have a circular shape when viewed from the outside. When the electronic device 3001 is in a second state, the display 3010 including the first display 3011 and the second display 3012 may have an elliptical shape when viewed from the outside.

According to an embodiment, when the electronic device 3001 is in the first state, the electronic device 3001 may be converted into the second state by a physical force of a user. In this case, a portion of the first display 3011 disposed inside the housing 3005 may be slid out of the housing 3005, and a portion of the second display 3012 disposed inside the housing 3005 may be slid out of the housing 3005.

According to an embodiment, a non-conductive member 3030 may be disposed at a central portion of the housing 3005 and may form a front surface of the electronic device 3001. The first conductive member 3071 and the second conductive member 3072 may be disposed below the non-conductive member 3030 to support the non-conductive member 3030.

According to an embodiment, the wireless communication circuit 3060 may feed power to at least one of the first conductive member 3071 or the second conductive member 3072 and may transmit and/or receive RF signals of a predetermined frequency band based on electrical paths formed in the first conductive member 3071 and the second conductive member 3072.

According to an embodiment, an electronic device 101 (e.g., a wearable device) may include a housing 210, a display 220 disposed on at least a portion of a front surface of the electronic device 101 (e.g., the wearable device), a first conductive member 311 included in the housing 210 or disposed within the housing 210, a second conductive member 312 disposed within the housing 210 adjacent to the first conductive member 311, a non-conductive member 240 disposed along one side of a region of the front surface 200 of the electronic device 101 (e.g., the wearable device) where the display 220 is exposed, the non-conductive member being supported by the first conductive member 311 and the second conductive member 312, and a wireless communication circuit 323. The wireless communication circuit 323 may be configured to feed power to the first conductive member 311 or the second conductive member 312 and to transmit and/or receive RF signals in a first frequency band based on an electrical path 520 formed in the first conductive member 311 and the second conductive member 312.

According to an embodiment, the first conductive member may be disposed along a first side of a bottom surface of the non-conductive member to support the non-conductive member, and the second conductive member may be disposed along a second side of the bottom surface of the non-conductive member to support the non-conductive member.

According to an embodiment, the electronic device may further include a printed circuit board on which the wireless communication circuit is disposed, the printed circuit board including a first region located between the first conductive member and the second conductive member and including a non-conductive material, and a portion of a conductive path electrically connecting the wireless communication circuit and the first conductive member may be formed on the first region.

According to an embodiment, the second conductive member may be electrically connected to a ground included in the printed circuit board, and the second conductive member may be disposed on the printed circuit board to support the non-conductive member.

According to an embodiment, a first conductive region electrically connecting the first conductive member and the second conductive member may be formed at a first end of the first region, and a second conductive region electrically connecting the first conductive member and the second conductive member may be formed at a second end of the first region.

According to an embodiment, a first conductive region electrically connecting the first conductive member and the second conductive member may be formed in the first region, and the first region between the first conductive member and the second conductive member may be divided into a plurality of slots by the first conductive region.

According to an embodiment, the second conductive member may be disposed adjacent to the first conductive member so as to be electromagnetically connectable to the first conductive member, and each of the first conductive member and the second conductive member may include a metal plate.

According to an embodiment, the non-conductive member disposed on the front surface of the wearable device may be included in the housing, and the non-conductive member may be disposed within a predetermined distance from one side of the region where the display is exposed so as to block the interior and the exterior of the housing from each other when a portion of the display is slid out of the housing or slid into the housing.

According to an embodiment, a dielectric material having a predetermined dielectric constant may be disposed between the first conductive member and the second conductive member.

According to an embodiment, the electronic device may include a printed circuit board on which the wireless communication circuit is disposed and a battery configured to supply power to the wireless communication circuit, the display may include a first display portion slid into the housing or slid out from the housing and a second display portion disposed on the front surface of the wearable device, and the first display portion may be disposed between the battery and the printed circuit board in a state in which the first display portion is slid into the housing.

According to an embodiment, the housing may include a first housing and a second housing, the second housing may be connected to the first housing so as to be movable in a direction away from the first housing or in a direction toward the first housing, and a portion of the display may be slid into the first housing or slid out from the first housing as the second housing moves.

According to an embodiment, the first housing may include a side surface member forming at least a portion of a side surface of the wearable device and a rear surface cover forming a rear surface of the wearable device, the first conductive member may be disposed adjacent to a first side surface portion of the side surface member facing the second housing, and the non-conductive member may be disposed along the first side surface portion.

According to an embodiment, the first side surface portion of the side surface member may include a non-conductive material.

According to an embodiment, the housing may include a first housing and a second housing including a first part located at a first end portion of the first housing and a second part located at a second end portion of the first housing, the first part of the second housing may move in a first direction to move away from the first housing, and the second part of the second housing may move in a second direction opposite to the first direction to move away from the first housing.

According to an embodiment, the display may include a first display moving together with the first part of the second housing and a second display moving together with the second part of the second housing, the first conductive member and the second conductive member may be disposed between the first display and the second display, and the non-conductive member may be disposed between the first display and the second display.

According to an embodiment, an electronic device 101 (e.g., a wearable device) may include a housing 2610, a flexible display disposed on at least a portion of a front surface of the wearable device 2601, a hinge 2670 connected to the flexible display so that the flexible display is folded or unfolded, a first conductive member 2711 included in the housing 2610 or disposed within the housing 2610, a second conductive member 2712 disposed within the housing 2610 adjacent to the first conductive member 2711, a non-conductive member 2670 disposed along one side of a region of the front surface of the wearable device 2601 where the display is exposed, the non-conductive member being supported by the first conductive member 2711 and the second conductive member 2712, and a wireless communication circuit 2760. The wireless communication circuit 2760 may be configured to feed power to the first conductive member 2711 or the second conductive member 2712 and to transmit and/or receive RF signals in a first frequency band based on an electrical path formed in the first conductive member 2711 and the second conductive member 2712.

According to an embodiment, the electronic device may further include a printed circuit board on which the wireless communication circuit is disposed, the printed circuit board including a first region located between the first conductive member and the second conductive member and including a non-conductive material, and a portion of a conductive path electrically connecting the wireless communication circuit and the first conductive member may be formed on the first region.

According to an embodiment, the second conductive member may be electrically connected to a ground included in the printed circuit board, and the second conductive member may be disposed on the printed circuit board to support the non-conductive member.

According to an embodiment, a first conductive region electrically connecting the first conductive member and the second conductive member may be formed at a first end of the first region, and a second conductive region electrically connecting the first conductive member and the second conductive member may be formed at a second end of the first region.

According to an embodiment, a first conductive region electrically connecting the first conductive member and the second conductive member may be formed in the first region, and the first region between the first conductive member and the second conductive member may be divided into a plurality of slots by the first conductive region.

## Claims

1. A wearable device comprising:
a housing;
a display disposed on at least a portion of a front surface of the wearable device;
a first conductive member included in the housing or disposed within the housing;
a second conductive member disposed within the housing adjacent to the first conductive member;
a non-conductive member disposed along one side of a region of the front surface of the wearable device that the display is exposed, wherein the non-conductive member is supported by the first conductive member and the second conductive member; and
a wireless communication circuit,
wherein the wireless communication circuit is configured to:
feed power to the first conductive member or the second conductive member; and
transmit and/or receive radio frequency (RF) signals of at least one frequency band based on an electrical path formed in the first conductive member and the second conductive member.

2. The wearable electronic device of claim 1, wherein the first conductive member is disposed along a first side of a bottom surface of the non-conductive member to support the non-conductive member, and
wherein the second conductive member is disposed along a second side of the bottom surface of the non-conductive member to support the non-conductive member.

3. The wearable electronic device of claim 1, further comprising:
a printed circuit board on which the wireless communication circuit is disposed,
wherein the printed circuit board includes a first region located between the first conductive member and the second conductive member and including a non-conductive material, and
wherein a portion of a conductive path electrically connecting the wireless communication circuit and the first conductive member is formed on the first region.

4. The wearable electronic device of claim 3, wherein the second conductive member is electrically connected to a ground included in the printed circuit board, and
wherein the second conductive member is disposed on the printed circuit board to support the non-conductive member.

5. The wearable electronic device of claim 3, wherein a first conductive region electrically connecting the first conductive member and the second conductive member is formed at a first end of the first region, and
wherein a second conductive region electrically connecting the first conductive member and the second conductive member is formed at a second end of the first region.

6. The wearable electronic device of claim 3, wherein a first conductive region electrically connecting the first conductive member and the second conductive member is formed in the first region, and
wherein the first region between the first conductive member and the second conductive member is divided into a plurality of slots by the first conductive region.

7. The wearable electronic device of claim 1, wherein the second conductive member is disposed adjacent to the first conductive member to be electromagnetically connectable to the first conductive member, and
wherein each of the first conductive member and the second conductive member includes a metal plate.

8. The wearable electronic device of claim 1, wherein the non-conductive member disposed on the front surface of the wearable device is included in the housing, and
wherein the non-conductive member is disposed within a predetermined distance from one side of the region that the display is exposed to block an exterior of the housing and an inside of the housing when a portion of the display is slid out of the housing or slid into the housing.

9. The wearable electronic device of claim 1, wherein a dielectric material having a predetermined dielectric constant is disposed between the first conductive member and the second conductive member.

10. The wearable electronic device of claim 1, further comprising:
a printed circuit board on which the wireless communication circuit is disposed; and
a battery configured to feed power to the wireless communication circuit,
wherein the display includes a first display portion slid into the housing or slid out from the housing and a second display portion disposed on the front surface of the wearable device, and
wherein the first display portion is disposed between the battery and the printed circuit board in a state in which the first display portion is slid into the housing.

11. The wearable electronic device of claim 1, wherein the housing includes a first housing and a second housing,
wherein the second housing is connected to the first housing to be movable in a direction away from the first housing or in a direction toward the first housing, and
wherein a portion of the display is slid into the first housing or slid out from the first housing as the second housing moves.

12. The wearable electronic device of claim 11, wherein the first housing includes a side surface member forming at least a portion of a side surface of the wearable device and a rear surface cover forming a rear surface of the wearable device,
wherein the first conductive member is disposed adjacent to a first side surface portion of the side surface member facing the second housing, and
wherein the non-conductive member is disposed along the first side surface portion.

13. The wearable electronic device of claim 12, wherein the first side surface portion of the side surface member includes a non-conductive material.

14. The wearable electronic device of claim 1, wherein the housing includes:
a first housing; and
a second housing including a first part located at a first end portion of the first housing and a second part located at a second end portion of the first housing,
wherein the first part of the second housing moves in a first direction to move away from the first housing, and
wherein the second part of the second housing moves in a second direction opposite to the first direction to move away from the first housing.

15. The wearable electronic device of claim 14, wherein the display includes a first display moving together with the first part of the second housing and a second display moving together with the second part of the second housing,
wherein the first conductive member and the second conductive member are disposed between the first display and the second display, and
wherein the non-conductive member is disposed between the first display and the second display.
